(19) **Europäisches Patentamt**
**European Patent Office**
**Office européen des brevets**

(11) **EP 4 436 076 A1**

(12) **EUROPEAN PATENT APPLICATION**
published in accordance with Art. 153(4) EPC

(43) Date of publication:
**25.09.2024 Bulletin 2024/39**

(21) Application number: **22906478.7**

(22) Date of filing: **12.12.2022**

(51) International Patent Classification (IPC):
**H04L 1/00** (2006.01) **H04L 1/18** (2023.01)

(52) Cooperative Patent Classification (CPC):
**H04L 1/00; H04L 1/18; H04L 1/1812**

(86) International application number:
**PCT/CN2022/138313**

(87) International publication number:
**WO 2023/109733 (22.06.2023 Gazette 2023/25)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **13.12.2021 CN 202111522959**

(71) Applicant: **Huawei Technologies Co., Ltd.**
**Shenzhen, Guangdong 518129 (CN)**

(72) Inventors:
• **DAI, Shengchen**
  **Shenzhen, Guangdong 518129 (CN)**

• **ZHANG, Huazi**
  **Ottawa, Ontario 518129 (CA)**
• **WANG, Xianbin**
  **Shenzhen, Guangdong 518129 (CN)**
• **LI, Rong**
  **Shenzhen, Guangdong 518129 (CN)**
• **WANG, Jun**
  **Shenzhen, Guangdong 518129 (CN)**

(74) Representative: **Gill Jennings & Every LLP**
**The Broadgate Tower**
**20 Primrose Street**
**London EC2A 2ES (GB)**

(54) **RATE MATCHING METHOD AND APPARATUS**

(57) This application provides a rate matching method, including: A transmitter obtains a to-be-coded bit sequence; the transmitter performs polar coding on the to-be-coded bit sequence, to obtain a first bit sequence, where a length of the first bit sequence is N; the transmitter performs first rate matching on the first bit sequence, to obtain a second bit sequence, where a length of the second bit sequence is $E_1$; the transmitter sends the second bit sequence; the transmitter performs polar coding based on the to-be-coded bit sequence, to obtain a third bit sequence, where a length of the third bit sequence is 2*N; the transmitter performs second rate matching on the third bit sequence, to obtain a fourth bit sequence, where a length of the fourth bit sequence is $E_2$, the second rate matching is determined based on a relationship between $f(E_1)$ and $E_2$, and a value of $f(E_1)$ is determined based on $E_1$; and the transmitter sends the fourth bit sequence, where N, $E_1$, and $E_2$ are positive integers.

FIG. 5

EP 4 436 076 A1

## Description

This application claims priority to Chinese Patent Application No. 202111522959.8, filed with the China National Intellectual Property Administration on December 13, 2021 and entitled "RATE MATCHING METHOD AND APPARATUS", which is incorporated herein by reference in its entirety.

## TECHNICAL FIELD

Embodiments of this application relate to the field of communication technologies, and in particular, to a rate matching method and apparatus.

## BACKGROUND

Channel coding/decoding (forward error correction) is one of key technologies in a communication system, and is very important for improvement of sensitivity and anti-interference of the system. Polar coding is first theoretically proved to be a channel coding manner that can achieve a Shannon capacity with low coding/decoding complexity and that can perform much better than other competitors in scenarios of a short code length or a low code rate. In a 5th generation (5th generation, 5G) communication system, the polar coding is determined as a coding manner of a control channel.

In a communication application that is insensitive to a system latency, a hybrid automatic repeat request (hybrid automatic repeat request, HARQ) is a common transmission method used to improve a system throughput rate. For a HARQ transmission method of polar code, an efficient solution is an incremental redundancy HARQ (incremental redundancy HARQ, IR-HARQ), which is usually classified as a HARQ-II (HARQ-II). In the IR-HARQ, when there is no rate matching (that is, no puncturing or shortening is required), stable performance can be achieved by selecting, based on a reliability sequence, a quantity and locations of bits that need to be copied. However, in an actual system, a quantity of resources for initial transmission and a quantity of resources for retransmission are not necessarily equal, and a quantity of bits obtained after coding for retransmission is less than a quantity of bits obtained after coding for initial transmission. In this case, a rate matching manner needs to be designed to ensure stable performance. Otherwise, the performance is defected by defective pixels because of an unexpected copy quantity and unexpected copy locations based on a long sequence. Therefore, how to design an appropriate rate matching method for the IR-HARQ becomes an urgent problem that needs to be resolved.

## SUMMARY

Embodiments of this application provide a rate matching method and apparatus, to ensure stable performance of an IR-HARQ.

According to a first aspect of this application, a rate matching method is provided, and includes:

A transmitter obtains a to-be-coded bit sequence; the transmitter performs polar coding on the to-be-coded bit sequence, to obtain a first bit sequence, where a length of the first bit sequence is N; the transmitter performs first rate matching on the first bit sequence, to obtain a second bit sequence, where a length of the second bit sequence is $E_1$; and the transmitter sends the second bit sequence; and

the transmitter performs polar coding based on the to-be-coded bit sequence, to obtain a third bit sequence, where a length of the third bit sequence is 2*N; the transmitter performs second rate matching on the third bit sequence, to obtain a fourth bit sequence, where a length of the fourth bit sequence is $E_2$, the second rate matching is determined based on a relationship between $f(E_1)$ and $E_2$, and a value of $f(E_1)$ is determined based on $E_1$; and the transmitter sends the fourth bit sequence, where N, $E_1$, and $E_2$ are positive integers.

The first aspect relates to a rate matching mechanism that can be applied to a transmitter side in an IR-HARQ, and a rate matching method is designed for each of an initial transmission bit sequence and a retransmission bit sequence, to fill a gap, in the conventional technology, that there is no rate matching method for the IR-HARQ. Further, a rate matching method designed for the retransmission bit sequence is determined based on a relationship between the initial transmission bit sequence and the retransmission bit sequence, and a flexible rate matching manner is designed for different correspondences between different quantities of retransmission bits and different quantities of initial transmission bits, so that the rate matching can exactly correspond to an actual situation, to ensure that performance of the IR-HARQ is always in a stable and excellent state.

In a possible implementation, $f(E_1)=a*E_1+b$, where a is a constant greater than 0 and less than or equal to 1, and b is a constant whose absolute value is less than $E_1$.

In a possible implementation, $f(E_1)=a*E_1+b$, where a and b are constants, and $f(E_1)$ is less than or equal to $E_1$.

In a possible implementation, when $E_2$ is greater than or equal to $f(E_1)$, the second rate matching is performed based on a fifth bit sequence; or when $E_2$ is less than $f(E_1)$, the second rate matching includes: puncturing all bits whose sequence numbers fall within $[0, N/2-1]$ in a fifth bit sequence, and performing third rate matching on all bits whose sequence number fall within $[N/2, N-1]$ in the fifth bit sequence, where the fifth bit sequence consists of all bits whose sequence numbers fall within $[0, N-1]$ in the third bit sequence.

In this implementation, the fifth bit sequence is a first half of the third bit sequence, that is, the fifth bit sequence consists of all the bits whose sequence numbers fall within $[0, N-1]$ in the third bit sequence. When $E_2$ is greater than or equal to $f(E_1)$, the second rate matching is performed based on the mother code length N. When $E_2$ is less than $f(E_1)$, the second rate matching is performed based on a half of the mother code length, that is, N/2.

In a possible implementation, when $E_2$ is greater than or equal to $f(E_1)$:

when $E_2$ is less than N, the second rate matching is bit reversal shortening; or when $E_2$ is greater than N, the second rate matching is repetition; or

when $E_2$ is less than $f(E_1)$:

when $E_2$ is less than N/2, the third rate matching is bit reversal shortening; or when $E_2$ is greater than N/2, the third rate matching is repetition, where

$f(E_1)$ is $E_1-N/16$.

In this implementation, a rate matching rule used when $f(E_1)$ is $E_1-N/16$, that is, a rate matching rule used when a=1 and b=-N/16, is described.

In a possible implementation, when $E_2$ is greater than or equal to $f(E_1)$,

the second rate matching includes: bit reversal shortening on the fifth bit sequence, and then puncturing in a natural order; or

when $E_2$ is less than $f(E_1)$,

the third rate matching is bit reversal shortening, where

$f(E_1)$ is $E_1/2$.

In this possible implementation, a rate matching rule used when $f(E_1)$ is $E_1/2$, that is, a rate matching rule used when a=1/2 and b=0, is described.

In a possible implementation, N is determined based on $E_1$. Specifically, $N=2^{\wedge}\lceil \log2(E_1) \rceil$.

In a possible implementation, the first rate matching is bit reversal shortening.

In the foregoing several implementations, a rate matching manner is designed as bit reversal shortening. In bit reversal shortening, because shortened locations are evenly distributed, a reliability order between bit locations is well retained. Therefore, stable performance is achieved in scenarios with various code lengths and code rates.

According to a second aspect of this application, a rate matching method is provided, and includes:

A receiver obtains a first sequence, where a length of the first sequence is $E_1$, and a mother code length corresponding to the first sequence is N; the receiver rate de-matches the first sequence and then decodes the rate de-matched first sequence based on a manner of first rate matching; the receiver obtains a second sequence, where a length of the second sequence is $E_2$; and the receiver rate de-matches a third sequence and then decodes a rate de-matched third sequence based on the manner of first rate matching and a manner of second rate matching, where the third sequence consists of the first sequence and the second sequence, a mother code length corresponding to the third sequence is 2*N, the second rate matching is determined based on a relationship between $f(E_1)$ and $E_2$, a value of $f(E_1)$ is determined based on $E_1$, and N, $E_1$, and $E_2$ are positive integers.

Correspondingly, the second aspect relates to a rate matching mechanism that can be applied to a receiver side in an IR-HARQ, where the first sequence corresponds to a second bit sequence, that is, an initial transmission bit sequence, of a transmitter, and the second sequence corresponds to a fourth bit sequence, that is, a retransmission bit sequence, of the transmitter, to fill a gap, in the conventional technology, that there is no rate matching method for the IR-HARQ. Further, a rate matching method designed for the retransmission bit sequence is determined based on a relationship between the initial transmission bit sequence and the retransmission bit sequence, and a flexible rate matching manner is designed for different correspondences between different quantities of retransmission bits and different quantities of initial transmission bits, so that the rate matching can exactly correspond to an actual situation, to ensure that performance of the IR-HARQ is always in a stable and excellent state.

In a possible implementation, $f(E_1)=a*E_1+b$, where a is a constant greater than 0 and less than or equal to 1, and b is a constant whose absolute value is less than $E_1$.

In a possible implementation, $f(E_1)=a*E_1+b$, where a and b are constants, and $f(E_1)$ is less than or equal to $E_1$.

In a possible implementation, when $E_2$ is greater than or equal to $f(E_1)$, the second rate matching is performed based on a fifth bit sequence; or when $E_2$ is less than $f(E_1)$, the second rate matching includes: puncturing all bits whose sequence numbers fall within [0, N/2-1] in a fifth bit sequence, and performing third rate matching on all bits whose sequence numbers fall within [N/2, N-1] in the fifth bit sequence, where the fifth bit sequence consists of all bits whose sequence numbers fall within [0, N-1] in the third bit sequence.

In this implementation, the fifth bit sequence is a first half of the third bit sequence, that is, the fifth bit sequence consists of all the bits whose sequence numbers fall within [0, N-1] in the third bit sequence. When $E_2$ is greater than or equal to $f(E_1)$, the second rate matching is performed based on the mother code length N. When $E_2$ is less than $f(E_1)$, the second rate matching is performed based on a half of the mother code length, that is, N/2.

In a possible implementation, when $E_2$ is greater than or equal to $f(E_1)$:

when $E_2$ is less than N, the second rate matching is bit reversal shortening; or when $E_2$ is greater than N, the second rate matching is repetition; or
when $E_2$ is less than $f(E_1)$:

when $E_2$ is less than N/2, the third rate matching is bit reversal shortening; or when $E_2$ is greater than N/2, the third rate matching is repetition, where
$f(E_1)$ is $E_1$-N/16.

In this possible implementation, a rate matching rule used when $f(E_1)$ is $E_1$-N/16, that is, a rate matching rule used when a=1 and b=-N/16, is described.

In a possible implementation, when $E_2$ is greater than or equal to $f(E_1)$,

the second rate matching includes: bit reversal shortening on the fifth bit sequence, and then puncturing in a natural order; or
when $E_2$ is less than $f(E_1)$,
the third rate matching is bit reversal shortening, where
$f(E_1)$ is $E_1/2$.

In this possible implementation, a rate matching rule used when $f(E_1)$ is $E_1/2$, that is, a rate matching rule used when a=1/2 and b=0, is described.

In a possible implementation, N is determined based on $E_1$. Specifically, $N=2^{\wedge \lceil \log2(E_1) \rceil}$.

In a possible implementation, the first rate matching is bit reversal shortening.

In the foregoing several implementations, a rate matching manner may be designed as bit reversal shortening. In bit reversal shortening, because shortened locations are evenly distributed, a reliability order between bit locations is well retained. Therefore, stable performance is achieved in scenarios with various code lengths and code rates.

According to a third aspect of this application, a rate matching apparatus is provided, and may be used for a transmitter. The apparatus includes a transceiver unit and a processing unit. The transceiver unit obtains a to-be-coded bit sequence; the processing unit performs polar coding on the to-be-coded bit sequence, to obtain a first bit sequence, where a length of the first bit sequence is N; the processing unit performs first rate matching on the first bit sequence, to obtain a second bit sequence, where a length of the second bit sequence is $E_1$; the transceiver unit sends the second bit sequence; the processing unit performs polar coding based on the to-be-coded bit sequence, to obtain a third bit sequence, where a length of the third bit sequence is 2*N; the processing unit performs second rate matching on the third bit sequence, to obtain a fourth bit sequence, where a length of the fourth bit sequence is $E_2$, the second rate matching is determined based on a relationship between $f(E_1)$ and $E_2$, and a value of $f(E_1)$ is determined based on $E_1$; and the transceiver unit sends the fourth bit sequence, where N, $E_1$, and $E_2$ are positive integers.

In a possible implementation, $f(E_1)=a*E_1+b$, where a is a constant greater than 0 and less than or equal to 1, and b is a constant whose absolute value is less than $E_1$.

In a possible implementation, $f(E_1)=a*E_1+b$, where a and b are constants, and $f(E_1)$ is less than or equal to $E_1$.

In a possible implementation, when $E_2$ is greater than or equal to $f(E_1)$, the second rate matching is performed based on a fifth bit sequence; or when $E_2$ is less than $f(E_1)$, the second rate matching includes: puncturing all bits whose sequence numbers fall within [0, N/2-1] in a fifth bit sequence, and performing third rate matching on all bits whose sequence numbers fall within [N/2, N-1] in the fifth bit sequence, where the fifth bit sequence consists of all bits whose sequence numbers fall within [0, N-1] in the third bit sequence.

In this implementation, the fifth bit sequence is a first half of the third bit sequence, that is, the fifth bit sequence consists of all the bits whose sequence numbers fall within [0, N-1] in the third bit sequence. When $E_2$ is greater than or equal to $f(E_1)$, the second rate matching is performed based on the mother code length N. When $E_2$ is less than $f(E_1)$, the second rate matching is performed based on a half of the mother code length, that is, N/2.

In a possible implementation, when $E_2$ is greater than or equal to $f(E_1)$:

when $E_2$ is less than N, the second rate matching is bit reversal shortening; or when $E_2$ is greater than N, the second rate matching is repetition; or
when $E_2$ is less than $f(E_1)$:

when $E_2$ is less than N/2, the third rate matching is bit reversal shortening; or when $E_2$ is greater than N/2, the third rate matching is repetition, where
$f(E_1)$ is $E_1$-N/16.

In this implementation, a rate matching rule used when $f(E_1)$ is $E_1$-N/16, that is, a rate matching rule used when a=1 and b=-N/16, is described.

In a possible implementation, when $E_2$ is greater than or equal to $f(E_1)$,

the second rate matching includes: bit reversal shortening on the fifth bit sequence, and then puncturing in a natural order; or
when $E_2$ is less than $f(E_1)$,
the third rate matching is bit reversal shortening, where
$f(E_1)$ is $E_1/2$.

In this possible implementation, a rate matching rule used when $f(E_1)$ is $E_1/2$, that is, a rate matching rule used when a=1/2 and b=0, is described.

In a possible implementation, N is determined based on $E_1$. Specifically, $N=2^{\wedge}\lceil \log2(E_1) \rceil$.

In a possible implementation, the first rate matching is bit reversal shortening.

According to a fourth aspect of this application, a rate matching apparatus is provided, and may be used for a receiver. The apparatus includes a transceiver unit and a processing unit. The transceiver unit obtains a first sequence, where a length of the first sequence is $E_1$, and a mother code length corresponding to the first sequence is N; the processing unit rate de-matches the first sequence and then decodes the rate de-matched first sequence based on a manner of first rate matching; the transceiver unit obtains a second sequence, where a length of the second sequence is $E_2$; and the processing unit rate de-matches a third sequence and then decodes a rate de-matched third sequence based on the manner of first rate matching and a manner of second rate matching, where the third sequence consists of the first sequence and the second sequence, a mother code length corresponding to the third sequence is 2*N, the second rate matching is determined based on a relationship between $f(E_1)$ and $E_2$, a value of $f(E_1)$ is determined based on $E_1$, and N, $E_1$, and $E_2$ are positive integers.

In a possible implementation, $f(E_1)=a*E_1+b$, where a is a constant greater than 0 and less than or equal to 1, and $b_i$ is a constant whose absolute value is less than $E_1$.

In a possible implementation, $f(E_1)=a*E_1+b$, where a and b are constants, and $f(E_1)$ is less than or equal to $E_1$.

In a possible implementation, when $E_2$ is greater than or equal to $f(E_1)$, the second rate matching is performed based on a fifth bit sequence; or when $E_2$ is less than $f(E_1)$, the second rate matching includes: puncturing all bits whose sequence numbers fall within [0, N/2-1] in a fifth bit sequence, and performing third rate matching on all bits whose sequence numbers fall within [N/2, N-1] in the fifth bit sequence, where the fifth bit sequence consists of all bits whose sequence numbers fall within [0, N-1] in the third bit sequence.

In this implementation, the fifth bit sequence is a first half of the third bit sequence, that is, the fifth bit sequence consists of all the bits whose sequence numbers fall within [0, N-1] in the third bit sequence. When $E_2$ is greater than or equal to $f(E_1)$, the second rate matching is performed based on the mother code length N. When $E_2$ is less than $f(E_1)$, the second rate matching is performed based on a half of the mother code length, that is, N/2.

In a possible implementation, when $E_2$ is greater than or equal to $f(E_1)$:

when $E_2$ is less than N, the second rate matching is bit reversal shortening; or when $E_2$ is greater than N, the second rate matching is repetition; or
when $E_2$ is less than $f(E_1)$:

when $E_2$ is less than N/2, the third rate matching is bit reversal shortening; or when $E_2$ is greater than N/2, the third rate matching is repetition, where

$f(E_1)$ is $E_1$-N/16.

In this possible implementation, a rate matching rule used when $f(E_1)$ is $E_1$-N/16, that is, a rate matching rule used when a=1 and b=-N/16, is described.

In a possible implementation, when $E_2$ is greater than or equal to $f(E_1)$,

the second rate matching includes: bit reversal shortening on the fifth bit sequence, and then puncturing in a natural order; or
when $E_2$ is less than $f(E_1)$,
the third rate matching is bit reversal shortening, where
$f(E_1)$ is $E_1/2$.

In this possible implementation, a rate matching rule used when $f(E_1)$ is $E_1/2$, that is, a rate matching rule used when a=1/2 and b=0, is described.

In a possible implementation, N is determined based on $E_1$. Specifically, $N=2^{\wedge}\lceil \log2(E_1)\rceil$ .

In a possible implementation, the first rate matching is bit reversal shortening.

According to a fifth aspect of embodiments of this application, a communication apparatus is provided. The communication apparatus includes a processor and a memory. The memory stores a computer program. The processor is configured to invoke and run the computer program stored in the memory, to enable the processor to implement any implementation of the first aspect.

According to a sixth aspect of embodiments of this application, a communication apparatus is provided. The communication apparatus includes a processor and a memory. The memory stores a computer program. The processor is configured to invoke and run the computer program stored in the memory, to enable the processor to implement any implementation of the second aspect.

According to a seventh aspect of embodiments of this application, a communication apparatus is provided. The communication apparatus includes a logic circuit and an input/output interface.

The input/output interface is configured to input a to-be-coded bit sequence; the input/output interface is further configured to output a second bit sequence and a fourth bit sequence; and the logic circuit is configured to implement any implementation of the first aspect.

According to an eighth aspect of embodiments of this application, a communication apparatus is provided. The communication apparatus includes a logic circuit and an input/output interface.

The input/output interface is configured to input a first sequence and a second sequence; and the logic circuit is configured to implement any implementation of the first aspect.

According to a ninth aspect of embodiments of this application, a computer program product including instructions is provided. When the computer program product is run on a computer, any implementation of the first aspect and the second aspect is performed.

According to a tenth aspect of embodiments of this application, a computer-readable storage medium is provided, and includes computer instructions. When the computer instructions are run on a computer, any implementation of the first aspect and the second aspect is performed.

According to an eleventh aspect of embodiments of this application, a chip apparatus is provided, and includes a processor, configured to be connected to a memory, and invoke a program stored in the memory, to enable the processor to perform any implementation of the first aspect and the second aspect.

According to a twelfth aspect of embodiments of this application, a communication system is provided. The communication system includes the apparatus according to the third aspect and the apparatus according to the fourth aspect.

For technical effects achieved in the third aspect to the twelfth aspect, refer to the technical effects in the first aspect or the second aspect. Details are not described herein.

## BRIEF DESCRIPTION OF DRAWINGS

FIG. 1 is a schematic diagram of a communication system according to an embodiment of this application;
FIG. 2 is a schematic diagram of coding and decoding of a polar code according to an embodiment of this application;
FIG. 3 is a schematic diagram of an IF-HARQ according to an embodiment of this application;

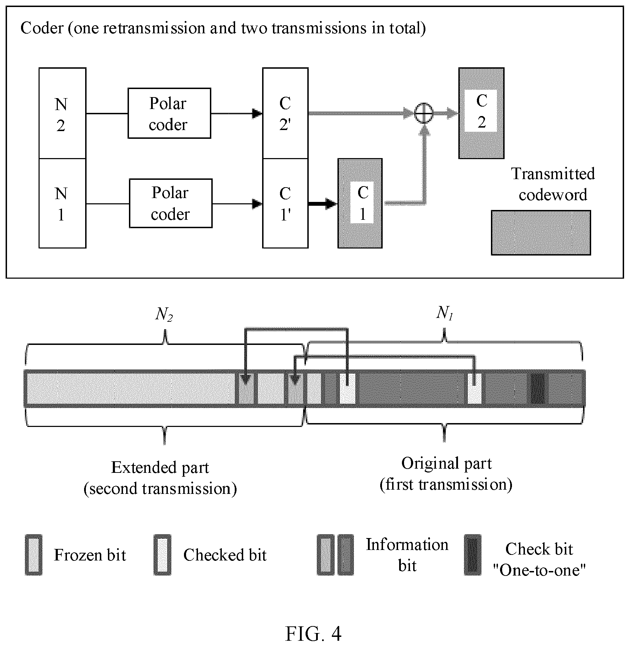

FIG. 4 is a schematic diagram of an IR-HARQ according to an embodiment of this application;
FIG. 5 is a schematic flowchart of a rate matching method according to an embodiment of this application;

FIG. 6 is a schematic operation diagram of a rate matching method designed based on an IR-HARQ structure according to an embodiment of this application;

FIG. 7 is a schematic diagram of an example of bit reversal shortening according to an embodiment of this application;

FIG. 8 is a schematic diagram of rate matching corresponding to a case in which $f(E_1)$ is represented as Ei-N/16 according to an embodiment of this application;

FIG. 9 is a schematic diagram of rate matching corresponding to a case in which $f(E_1)$ is represented as Ei/2 according to an embodiment of this application;

FIG. 10 is a schematic diagram of a rate matching apparatus according to an embodiment of this application;

FIG. 11 is a schematic diagram of another rate matching apparatus according to an embodiment of this application;

FIG. 12 is a schematic diagram of another rate matching apparatus according to an embodiment of this application;

FIG. 13 is a performance simulation diagram according to an embodiment of this application; and

FIG. 14A, FIG. 14B, and FIG. 14C are another performance simulation diagram according to an embodiment of this application.

## DESCRIPTION OF EMBODIMENTS

This application provides a rate matching method and apparatus, to ensure stable performance of an IR-HARQ.

In the specification and accompanying drawings of this application, the terms "first", "second", and the like are used to distinguish between different objects or distinguish between different processing of a same object, and are not used to describe a particular order of the objects. In addition, the terms "include" and "have", and any variants thereof in descriptions of this application are intended to cover a non-exclusive inclusion. For example, a process, a method, a system, a product, or a device that includes a series of steps or units is not limited to listed steps or units, but optionally further includes other unlisted steps or units, or optionally further includes another step or unit inherent to the process, the method, the product, or the device. In embodiments of this application, "a plurality of" includes two or more, and a "system" and a "network" may be replaced with each other. In embodiments of this application, the word such as "example" or "for example" is used to represent giving an example, an illustration, or a description. Any embodiment or design solution described as an "example" or "for example" in embodiments of this application should not be explained as being more preferred or having more advantages than another embodiment or design solution. Exactly, use of the word such as "example" or "for example" is intended to present a related concept in a specific manner.

The communication method provided in embodiments of this application may be applied to various communication systems, for example, a satellite communication system, an internet of things (internet of things, IoT), a narrow band internet of things (narrow band internet of things, NB-IoT) system, a global system for mobile communications (global system for mobile communications, GSM), an enhanced data rate for GSM evolution (enhanced data rate for GSM evolution, EDGE) system, a wideband code division multiple access (wideband code division multiple access, WCDMA) system, a code division multiple access 2000 (code division multiple access, CDMA2000) system, a time division-synchronous code division multiple access (time division-synchronous code division multiple access, TD-SCDMA) system, a long term evolution (long term evolution, LTE) system, a 5th generation (5G) communication system, for example, 5G new radio (new radio, NR) and three application scenarios of a 5G mobile communication system: enhanced mobile broadband (enhanced mobile broadband, eMBB), ultra-reliable and low-latency communications (ultra-reliable and low-latency communications, URLLC), and massive machine type communications (massive machine type communications, mMTC), a device-to-device (device-to-device, D2D) communication system, a machine-to-machine (machine-to-machine, M2M) communication system, an internet of vehicles communication system, or another or future communication system. This is not specifically limited in embodiments of this application.

The following describes embodiments of this application with reference to the accompanying drawings in embodiments of this application. Terms used in implementations of this application are merely used to explain specific embodiments of this application, and are not intended to limit this application.

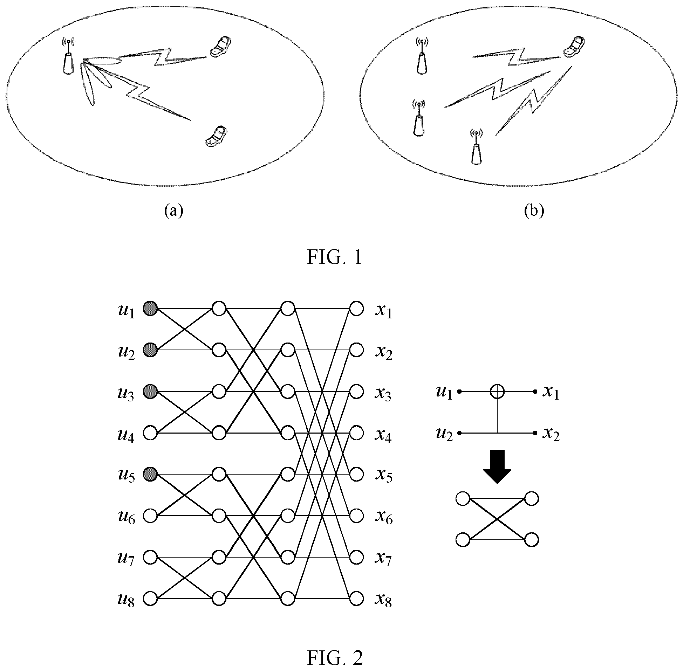

For ease of understanding embodiments of this application, an application scenario used in embodiments of this application is described by using a network architecture shown in FIG. 1. The network architecture may be used in the foregoing various communication systems. The communication system shown in FIG. 1 includes a network device and a terminal. In this application, both a transmitter and a receiver may be network devices or terminals. This is not limited in this application. The network device and the terminal may perform wireless communication by using a resource. Types and quantities of network devices and terminal devices are not limited in embodiments of this application. As shown in (a) in FIG. 1, there may be one or more terminal devices. As shown in (b) in FIG. 1, there may also be one or more network devices. The resource herein may include one or more of a time domain resource, a frequency domain resource, a code domain resource, and a space domain resource. In addition, this application is also applicable to a system in which terminals communicate with each other, and is also applicable to a system in which network devices communicate with each other.

The terminal includes a device that provides voice and/or data connectivity for a user. Specifically, the terminal includes a device that provides voice for the user, includes a device that provides data connectivity for the user, or includes a device that provides voice and data connectivity for the user. For example, the terminal may include a handheld device with a wireless connection function or a processing device connected to a wireless modem. The terminal device may communicate with a core network through a radio access network (radio access network, RAN), and exchange voice or data with the RAN, or exchange voice and data with the RAN. The terminal device may include user equipment (user equipment, UE), a wireless terminal device, a mobile terminal device, a device-to-device (device-to-device, D2D) terminal device, a vehicle-to-everything (vehicle-to-everything, V2X) terminal device, a machine-to-machine/machine type communications (machine-to-machine/machine type communications, M2M/MTC) terminal device, an internet of things (internet of things, IoT) terminal device, a light terminal device (light UE), a subscriber unit (subscriber unit), a subscriber station (subscriber station), a mobile station (mobile station), a remote station (remote station), an access point (access point, AP), a remote terminal (remote terminal), an access terminal (access terminal), a user terminal (user terminal), a user agent (user agent), an uncrewed aerial vehicle, a user device (user device), or the like. For example, the terminal device may include a mobile phone (or referred to as a "cellular" phone), a computer having a mobile terminal device, or a portable, pocket-sized, handheld, or a computer-embedded mobile apparatus. For example, the terminal device is a device such as a personal communications service (personal communications service, PCS) phone, a cordless phone, a session initiation protocol (session initiation protocol, SIP) phone, a wireless local loop (wireless local loop, WLL) station, or a personal digital assistant (personal digital assistant, PDA). The terminal device further includes a limited device, for example, a device having low power consumption, a device having a limited storage capability, or a device having a limited computing capability. For example, the terminal device includes an information sensing device such as a barcode, radio frequency identification (radio frequency identification, RFID), a sensor, a global positioning system (global positioning system, GPS), or a laser scanner.

By way of example, and not limitation, in embodiments of this application, the terminal may alternatively be a wearable device. The wearable device may also be referred to as a wearable intelligent device, an intelligent wearable device, or the like, and is a general term of wearable devices that are intelligently designed and developed for daily wear by using a wearable technology, for example, glasses, gloves, watches, clothes, and shoes. The wearable device is a portable device that is directly worn on a body or integrated into clothes or an accessory of a user. The wearable device is not merely a hardware device, but is used to implement a powerful function through software support, data exchange, and cloud interaction. In a broad sense, the wearable intelligent device includes a full-featured and large-sized device that can implement all or some of functions without depending on a smartphone, for example, a smart watch or smart glasses, and includes a device that provides only one type of application function and that needs to be used in combination with another device such as a smartphone, for example, various smart bands, various smart helmets, or various pieces of smart jewelry for monitoring physical signs.

If the various terminals described above are located in a vehicle (for example, placed in the vehicle or installed in the vehicle), all of the terminals may be considered as vehicle-mounted terminals. For example, the vehicle-mounted terminal device is also referred to as an on-board unit (on-board unit, OBU).

In embodiments of this application, the terminal may further include a relay (relay). Alternatively, it is understood that any device that can perform data communication with a base station may be considered as the terminal device.

In embodiments of this application, an apparatus configured to implement a function of the terminal may be a terminal, or may be an apparatus that can support the terminal device in implementing the function, for example, a chip system. The apparatus may be installed in the terminal. In embodiments of this application, the chip system may include a chip, or may include a chip and another discrete device. In the technical solutions provided in embodiments of this application, the technical solutions provided in embodiments of this application are described by using an example in which the apparatus configured to implement the function of the terminal is a terminal.

The network device includes, for example, an access network (access network, AN) device such as a base station (for example, an access point), and may be a device that communicates with a wireless terminal device through an air interface in one or more cells in an access network. Alternatively, for example, the network device is a roadside unit (roadside unit, RSU) in a vehicle-to-everything (vehicle-to-everything, V2X) technology. The base station may be configured to perform mutual conversion between a received over-the-air frame and an IP packet, to serve as a router between the terminal device and a remaining part of the access network. The remaining part of the access network may include an IP network. The RSU may be a fixed infrastructure entity supporting a V2X application, and may exchange a message with another entity supporting the V2X application. The network device may further coordinate attribute management of the air interface. For example, the network device may include an evolved NodeB (NodeB, eNB, or e-NodeB, evolved NodeB) in a long term evolution (long term evolution, LTE) system or long term evolution-advanced (long term evolution-advanced, LTE-A), may include a next generation NodeB (next generation NodeB, gNB) in a 5th generation (5th generation, 5G) NR system (which is also briefly referred to as an NR system), may include a central unit (central unit, CU) and a distributed unit (distributed unit, DU) in a cloud radio access network (cloud radio access network, Cloud RAN) system, or may be an apparatus that carries a function of the network device in a future communication system. This is not limited in embodiments of this application.

The network device may further include a core network device. For example, the core network device includes an access and mobility management function (access and mobility management function, AMF) or a user plane function (user plane function, UPF).

Alternatively, the network device may be an apparatus that carries a function of the network device in device-to-device (Device-to-Device, D2D) communication, machine-to-machine (Machine-to-Machine, M2M) communication, an internet of vehicles, an uncrewed aerial vehicle system, or a satellite communication system.

It should be noted that only manners of communication between some network elements are listed above. Other network elements may communicate with each other in some connection manners. Details are not described herein in embodiments of this application.

A system architecture and a service scenario described in embodiments of this application are intended to describe the technical solutions in embodiments of this application more clearly, and do not constitute a limitation on the technical solutions provided in embodiments of this application. A person of ordinary skill in the art may learn that with evolution of a network architecture and emergence of a new service scenario, the technical solutions provided in embodiments of this application are also applicable to a similar technical problem.

For ease of understanding embodiments of this application, the following explains and describes some terms in embodiments of this application, to facilitate understanding by a person skilled in the art.

1. Polar code

The polar code is a linear block code. A generator matrix of the polar code is $G_N$, and a coding process of the polar code is $x_1^N = u_1^N G_N$. Herein, $u_1^N = (u_1, u_2, \ldots, u_N)$ is a binary row vector whose length is $N$ (that is, a code length), $G_N$ is an $N \times N$ matrix, and $G_N = B_N F_2^{\otimes(\log_2(N))}$. Herein, $F_2 = \begin{bmatrix} 1 & 0 \\ 1 & 1 \end{bmatrix}$, $B_N$ is an $N \times N$ transpose matrix, for example, a bit reversal matrix, and $F_2^{\otimes(\log_2(N))}$ is defined as a Kronecker (Kronecker) product of $\log_2 N$ matrices $F_2$. All of the foregoing addition and multiplication operations are addition and multiplication operations in a binary Galois field (Galois Field). In the coding process of the polar code, some bits in $u_1^N$ are used to carry information, and are referred to as information bits, and a set of indexes of these bits is denoted as $I$; and the other bits are set to a fixed value agreed on by a receiver and a transmitter in advance, and are referred to as fixed bits, and a set of indexes of these bits is represented by using a complementary set $F \triangleq I^c$ of $I$. The information bit sequence number set $I$ is selected based on the following method: A polar channel error probability $P_e^{(i)}$ corresponding to a bit whose sequence number is i may be obtained by using a method such as density evolution or Gaussian approximation, and K sequence numbers with a smallest $P_e^{(i)}$ value are selected to form the set $\mathcal{I}$.

In addition to a representation manner of a generator matrix, the polar code may be represented by using a coding/decoding diagram. FIG. 2 is a coding/decoding diagram of a polar code whose code length is N=8 and information length is K=4. Each "butterfly plot" represents one time of polarization of 2 bits, that is, $x_1^2 = u_1^2 G_2$. In this example, $\mathcal{I} = \{u_4, u_6, u_7, u_8\}$ is an information bit, and $\mathcal{F}^c = \{u_1, u_2, u_3, u_5\}$ is a frozen bit.

2. Hybrid automatic repeat request (hybrid automatic repeat request, HARQ)

In a communication application that is insensitive to a system latency, the HARQ is a common transmission method used to improve a system throughput rate. When transmitting an information block, a transmitter codes the information block, and then sends the information block to a channel. If a receiver finds, after decoding a received signal, that transmission fails (for example, cyclic redundancy check cannot be successfully performed), the receiver transmits a negative acknowledgment (negative acknowledgment, NACK) message to the transmitter over a feedback link, and the transmitter retransmits the information block. This process continues until the receiver performs correct decoding. In this case, the receiver sends an acknowledgment (acknowledgment, ACK) message to the transmitter, to complete transmission of the information block. To obtain a link throughput rate that is as high as possible, the receiver buffers all received signals, and decodes the received signals together with a newly received signal.

3. Chase combining hybrid automatic repeat request (chase combining hybrid automatic repeat request, CC-HARQ)

A classic HARQ solution 1 is the CC-HARQ, that is, a HARQ-I (HARQ-I). In this solution, a transmitter sends same coded data each time retransmission is performed; and a receiver directly adds all received signals, and then performs decoding. As a quantity of retransmissions increases, energy of combined received signals gradually increases, and decoding performance is enhanced. However, in this method, only an energy gain of retransmission can be obtained, and there is no coding gain of retransmission.

4. Incremental freezing hybrid automatic repeat request (incremental freezing hybrid automatic repeat request, IF-HARQ)

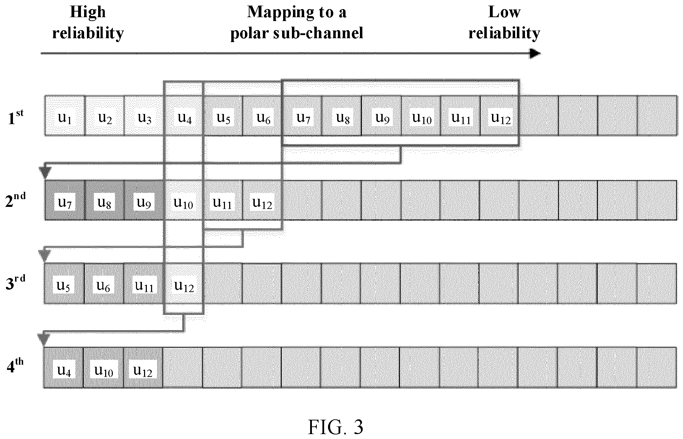

An existing HARQ transmission method in the polar code field is referred to as the IF-HARQ. As shown in FIG. 3, in this method, during each retransmission, a transmitter selects some information bits with lowest reliability from a sequence number set for previous transmissions based on reliability of each polar channel that is calculated by using a method such as density evolution/Gaussian approximation or a nested reliability sequence when a polar code is constructed, and performs polar coding and sending again. A receiver performs successive cancellation decoding based on a received signal, that is, first decodes latest received information data, and applies a decoding result as a frozen bit to previously received data until first received data is successfully decoded. In this solution, a coding gain may be brought by coding again.

As a quantity of retransmissions increases, a code rate gradually decreases, and the coding gain of the IF-HARQ also decreases. When there is a very low code rate, the coding gain is even negative (poorer than that of the CC-HARQ). In addition, if a codeword of a retransmission part is incorrectly decoded due to impact of a channel environment, and these incorrect information bits are used as frozen bits of an initial transmission part, adverse impact is exerted on decoding of the initial transmission part.

From another perspective, in the IF-HARQ, a short code is transmitted during each transmission. If strong noise or interference is received during a transmission, correct decoding cannot be performed, and consequently incorrect propagation is caused. That is, there is a lack of coupling between codeword bits, reliability of a current decoding sub-block cannot be enhanced by decoding adjacent codewords, and a gain brought by a code length increase cannot be obtained. This is a source of a loss of the coding gain. Therefore, it is not appropriate to simply use the IF-HARQ in a retransmission solution of the polar code.

5. Incremental redundancy hybrid automatic repeat request (incremental redundancy hybrid automatic repeat request, IR-HARQ)

Another type of HARQ in the polar code field is referred to as the IR-HARQ, and is usually classified as a HARQ-II (HARQ-II). A basic idea of the solution is to combine an initial transmission codeword and a retransmission codeword into a long code for decoding by using a nesting feature of a polar code. During initial transmission, a transmitter performs CRC coding on information data, and codes the information data into a short polar codeword at a corresponding code rate. During each retransmission, a polar code length and a kernel are extended based on a retransmission length; an extended part is searched for a sub-channel whose reliability is higher than that of an initial transmission part, the sub-channel is used as a new information bit, and an unreliable information bit in the corresponding initial transmission part is converted into a redundant information bit; a value of the redundant information bit is assigned to the new information bit, and a "one-to-one" check relationship between the redundant information bit and the new information bit is constructed; and polar coding is performed to generate an incremental redundant bit. A receiver combines all received signals into a long codeword based on a coder structure, and then sends the codeword to a decoder for decoding. During decoding, because the redundant information bit is used as a check bit, a value of the check bit may be determined based on a decoding result of the new information bit. As a quantity of retransmissions increases, a quantity of received redundant bits gradually increases, and a code rate of a long code obtained after combination gradually decreases. Therefore, decoding performance is enhanced. In addition to an energy gain, this method may further bring an additional coding gain by increasing the redundant bit.

A coding process of information bits and codeword bits for a first transmission and a second transmission in the IR-HARQ may be expressed by using the following formula:

$$\text{Copy}\left[\begin{bmatrix} u_2 \\ u_1 \end{bmatrix}^T \times \begin{bmatrix} G_N & 0 \\ G_N & G_N \end{bmatrix}\right] = \begin{bmatrix} c_2+c_1 \\ c_1 \end{bmatrix}^T$$

Herein, for the first transmission, an information side vector is denoted as u 1 (including information bits and frozen bits), and a codeword bit vector is c1; and for the second transmission, an information side vector is denoted as u2 (including information bits and frozen bits, where the transmitted information bits are exactly the same as some of the information bits in u1, and therefore this operation is referred to as "copy (copy)"), and a codeword bit vector is c2+c1, where "+" is binary addition, that is, an exclusive OR operation.

However, since rate matching is not performed in the IR-HARQ, the IR-HARQ does not have stable performance and may be defected by defective pixels (the performance of the IR-HARQ is poorer than that of the CC-HARQ).

It may be learned from the foregoing descriptions that the CC-HARQ and the IF-HARQ have disadvantages. If the CC-HARQ and the IF-HARQ are directly applied to the polar code field, performance is not ideal enough. The IR-HARQ is a known efficient retransmission manner, but currently there is no rate matching method for the IR-HARQ. In the IR-HARQ, when there is no rate matching (that is, no puncturing or shortening is required), stable performance can be achieved by selecting, based on a reliability sequence, a quantity and locations of bits that need to be copied. However, in an actual system, a quantity of resources for initial transmission and a quantity of resources for retransmission are not necessarily equal, and a quantity of bits obtained after coding for retransmission is less than a quantity of bits obtained after coding for initial transmission. To obtain stable performance, in this case, a rate matching manner needs to be introduced and designed. Otherwise, the performance is defected by defective pixels because of an unexpected copy quantity and unexpected copy locations based on a long sequence.

In view of this, in the technical solutions of this application, a corresponding rate matching manner is designed for the IR-HARQ, to ensure stability of the retransmission.

The technical solutions of this application are described below with reference to specific embodiments.

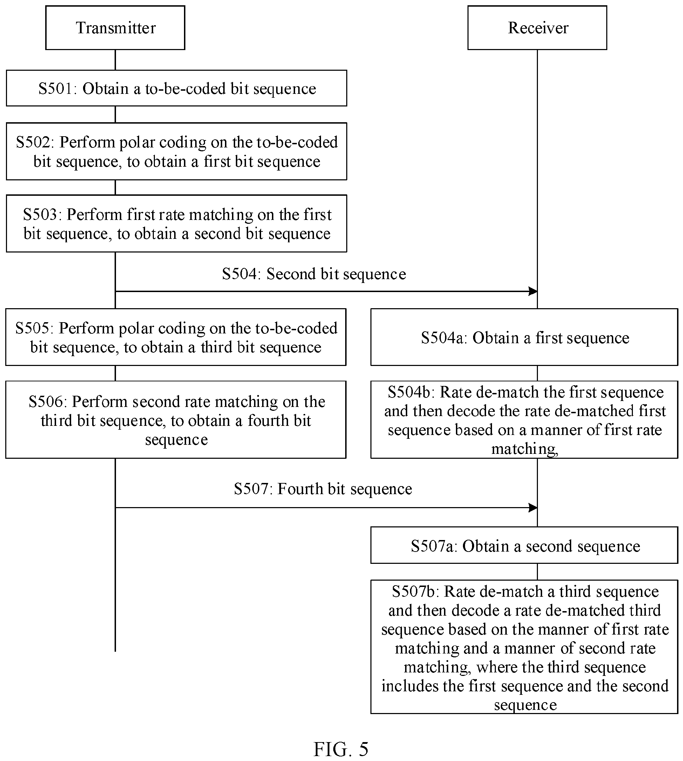

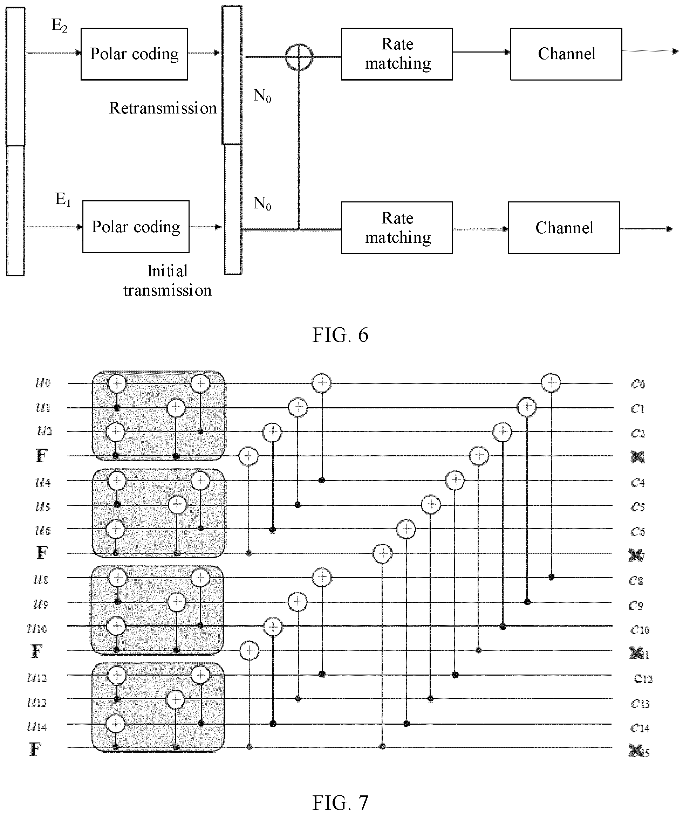

FIG. 5 is a schematic flowchart of a rate matching method according to an embodiment of this application. FIG. 6 is a schematic operation diagram of a corresponding rate matching method designed based on an IR-HARQ structure.

S501: A transmitter obtains a to-be-coded bit sequence.

S502: The transmitter performs polar coding on the to-be-coded bit sequence, to obtain a first bit sequence.

It should be noted that the first bit sequence may be referred to as a mother code of an initial transmission bit sequence, and a length of the first bit sequence is N.

S503: The transmitter performs first rate matching on the first bit sequence, to obtain a second bit sequence.

It should be noted that the second bit sequence may be referred to as the initial transmission bit sequence, and a length of the second bit sequence is $E_1$, that is, a quantity of initial transmission bits is $E_1$.

In a possible implementation, the first rate matching may be bit reversal shortening or a bit reversal shortening-based rate matching method, or may be an existing rate matching method in an existing standard.

For ease of understanding, FIG. 7 is used as an example herein to explain bit reversal shortening. As shown in FIG. 7, the mother code length is 16 bits. If a length after coding is set to 12 bits, four bit locations need to be shortened. A sequence number of each bit location is denoted as a sequence number that falls within [1, 15]. In this case, four bit locations with largest sequence numbers are respectively bit locations corresponding to sequence numbers 12, 13, 14, and 15, that is, four bit locations with lowest reliability rankings, and corresponding binary representations of the bit locations are [12(1100), 13(1101), 14(1110), 15(1111)]. The 4-bit binary representations are reversed, and [3(0011), 11(1011), 7(0111), 15(1111)] may be obtained. That is, after a bit reversal operation is performed, locations that finally need to be shortened are bit locations corresponding to sequence numbers 3, 11, 7, and 15. It may be learned that for a sequence obtained after bit reversal shortening, shortened locations of the sequence are evenly distributed, and a reliability order between bit locations is well retained. Therefore, stable performance is achieved in scenarios with various code lengths and various code rates.

In addition to using the rate matching method of bit reversal shortening for the first bit sequence, a rate matching manner specified in an existing new radio (new radio, NR) protocol may be used. That is, a polar code is equally divided into 32 groups, a quantity of bits in each group is N/32, and a to-be-punctured or to-be-shortened location is selected on a group basis, that is, based on a priority of an indicated sequence. If a quantity of remaining to-be-punctured or to-be-shortened bits is insufficient to form one group, the remaining to-be-punctured or to-be-shortened bits are sequentially selected from the group. The to-be-shortened location is symmetrical to the to-be-punctured location, that is, is selected from back to front.

S504: The transmitter sends the second bit sequence to a receiver.

Correspondingly, there is S504a: The receiver obtains a first sequence.

It should be noted that the first sequence received by the receiver is related to the second bit sequence sent by the transmitter, and a length of the first sequence is $E_1$.

S504b: The receiver rate de-matches the first sequence and then decodes the rate de-matched first sequence based on a manner of first rate matching.

It should be noted that an operation of the receiver corresponds to that of the transmitter. A difference lies in that the transmitter performs coding, and the receiver performs decoding. Therefore, similarly, a decoding manner of the receiver is also performed based on the first rate matching. Details are not described herein.

S505: The transmitter performs polar coding on the to-be-coded bit sequence, to obtain a third bit sequence.

It should be noted that the third bit sequence herein may be referred to as a combination of a to-be-retransmitted bit sequence and the first bit sequence, and a length of the third bit sequence is 2*N, that is, twice the length of the initial transmission mother code.

S506: The transmitter performs second rate matching on the third bit sequence, to obtain a fourth bit sequence.

It should be noted that the fourth bit sequence may be referred to as a retransmission bit sequence, and a length of the fourth bit sequence is $E_2$. The second rate matching is determined based on a relationship between $f(E_1)$ and $E_2$, and a value of $f(E_1)$ is determined based on $E_1$.

S507: The transmitter sends the fourth bit sequence to the receiver.

Correspondingly, there is S507a: The receiver obtains a second sequence.

It should be noted that the second sequence received by the receiver is related to the fourth bit sequence sent by the transmitter, and a length of the second sequence is $E_2$.

S507b: The receiver rate de-matches a third sequence and then decodes a de-matched third sequence based on the manner of first rate matching and a manner of second rate matching, where the third sequence consists of the first sequence and the second sequence.

It should be noted that an operation of the receiver corresponds to that of the transmitter. A difference lies in that the transmitter performs coding, and the receiver performs decoding. Therefore, similarly, a decoding manner of the receiver is also performed based on the manner of first rate matching and the second rate matching. Details are not described herein.

It may be learned that in the foregoing method, a rate matching mechanism that can be applied to a transmitter side in an IR-HARQ is designed, and a rate matching method is designed for each of the initial transmission bit sequence and the retransmission bit sequence, to fill a gap, in the conventional technology, that there is no rate matching method for the IR-HARQ. Further, a rate matching method designed for the retransmission bit sequence is determined based on a relationship between the initial transmission bit sequence and the retransmission bit sequence, and a flexible rate matching manner is designed for different correspondences between different quantities of retransmission bits and different quantities of initial transmission bits, so that the rate matching can exactly correspond to an actual situation, to ensure that performance of the IR-HARQ is always in a stable and excellent state.

In a possible implementation, that the second rate matching is determined based on a relationship between $E_1$ and $E_2$ may be specifically reflected as that the second rate matching is determined based on the relationship between $f(E_1)$ and $E_2$, where $f(E_1)$ is a function of $E_1$.

In a possible implementation, the second rate matching is determined based on a relationship between $f(E_1, R)$ and $E_2$, where $f(E_1, R)$ is a function of $E_1$ and R, R=K/$E_1$ and is a transmission code rate, K is a quantity of to-be-coded bits, and K is a positive integer.

In a possible implementation, $f(E_1)$ may be represented as a*$E_1$+b, where a is a constant greater than 0 and less than or equal to 1, and b is a constant whose absolute value is less than $E_1$.

In a possible implementation, when $E_2$ is greater than or equal to $f(E_1)$, the second rate matching is performed based on a fifth bit sequence; or

when $E_2$ is less than $f(E_1)$, the second rate matching includes: puncturing all bits whose sequence numbers fall within [0, N/2-1] in a fifth bit sequence, and performing third rate matching on all bits whose sequence numbers fall within [N/2, N-1] in the fifth bit sequence.

In this implementation, the fifth bit sequence is a first half of the third bit sequence, that is, the fifth bit sequence consists of all bits whose sequence numbers fall within [0, N-1] in the third bit sequence. When $E_2$ is greater than or equal to $f(E_1)$, the second rate matching is performed based on the mother code length N. When $E_2$ is less than $f(E_1)$, the second rate matching is performed based on a half of the mother code length, that is, N/2.

In a possible implementation, $f(E_1)$ is represented as $E_1$-N/16. A specific retransmission rate matching rule in this implementation is as follows:

When $E_2$ is greater than or equal to $E_1$-N/16:

(1) When $E_2$ is less than N, the second rate matching is bit reversal shortening, that is, the transmitter performs bit reversal shortening on the to-be-retransmitted bit sequence until the length of the retransmission bit sequence that is finally transmitted is $E_2$.

(2) When $E_2$ is greater than or equal to N, the second rate matching is repetition, that is, the transmitter performs a repetition operation on the to-be-retransmitted bit sequence until the length of the retransmission bit sequence that is finally transmitted is $E_2$.

When $E_2$ is less than $E_1$-N/16:

(1) When $E_2$ is less than N/2, the third rate matching is bit reversal shortening, that is, the transmitter performs bit reversal shortening on the to-be-retransmitted bit sequence until the length of the retransmission bit sequence that is finally transmitted is $E_2$.

(2) When $E_2$ is less than N/2, the third rate matching is repetition, that is, the transmitter performs a repetition operation on the to-be-retransmitted bit sequence until the length of the retransmission bit sequence that is finally transmitted is $E_2$.

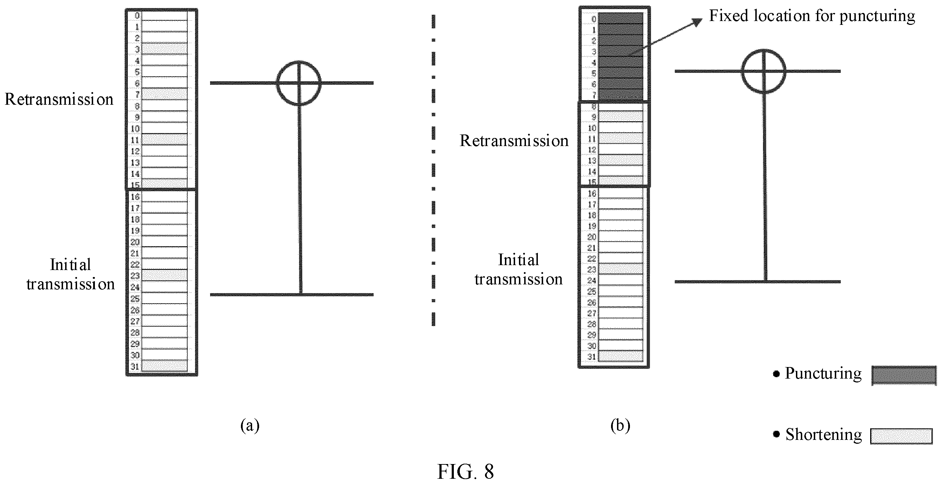

For ease of understanding, FIG. 8 is used as an example herein for further explanation. It is assumed that the length $E_1$ of the initial transmission bit sequence is 14 bits, and the mother code length N corresponding to the initial transmission bit sequence is 16 bits. Therefore, two bit locations need to be shortened. Based on bit reversal shortening, a sequence number of each bit location is denoted as a sequence number that falls within [1, 15]. In this case, two bit locations with largest sequence numbers are respectively bit locations corresponding to sequence numbers 14 and 15, and corresponding binary representations of the bit locations are [14(1110), 15(1111)]. The 4-bit binary representations are reversed, and [7(0111), 15(1111)] may be obtained. That is, after a bit reversal operation is performed, locations that finally need to be shortened are bit locations corresponding to sequence numbers 7 and 15. In FIG. 8, the initial transmission bit sequence and the retransmission bit sequence are combined into a long code. Therefore, the mother code length N is added to all bit locations in the initial transmission bit sequence. In this case, shortened bit locations are changed to bit locations corresponding to sequence numbers 23 and 31.

After the initial transmission bit sequence is determined, rate matching is performed below for retransmission. It is assumed that the length $E_2$ of the retransmission bit sequence is 13 bits. In this case, $f(E_1)=E_1-N/16=12$, and a condition that $E_2$ is greater than or equal to Ei-N/16 is met. Therefore, a rate matching method shown in (a) in FIG. 8 is used. Further, a condition that $E_2$ is less than N is met. Therefore, the retransmission part is shortened to 13 bits based on bit reversal. It may be learned from the foregoing bit reversal shortening method that shortened bit locations are [7(0111), 11(1011), 15(1111)], that is, locations that finally need to be shortened are bit locations corresponding to sequence numbers 7, 11, and 15. It is assumed that the length $E_2$ of the retransmission bit sequence is 4 bits. In this case, a condition that $E_2$ is less than Ei-N/16 is met. Therefore, a rate matching method shown in (b) in FIG. 8 is used. Further, a condition that $E_2$ is less than N/2 is met. Therefore, bit locations whose sequence numbers fall within [0, 7] in the retransmission part are fixed punctured locations, and then the remaining N/2 bit locations, that is, bit locations whose sequence numbers fall within [8, 15], are shortened to 4 bits according to a bit reversal shortening method. It may be learned from the foregoing bit reversal shortening method that locations that are finally shortened are bit locations corresponding to sequence numbers 9, 11, 13, and 15.

The foregoing is merely an example in which $f(E_1)=a*E_1+b$, that is, an example in which a is 1 and b is -N/16. In another possible implementation, a may be any value greater than 0 and less than or equal to 1, for example, 7/8, 5/6, or 3/4. In addition, b may be any number whose absolute value is less than $E_1$.

In a possible implementation, $f(E_1)$ is represented as $E_1/2$. A specific retransmission rate matching rule in this implementation is as follows:

(1) When $E_2$ is greater than or equal to $E_1/2$,
bit reversal shortening is performed on the fifth bit sequence, and then puncturing is performed in a natural order.
(2) When $E_2$ is less than Ei/2,
the third rate matching is bit reversal shortening.

It should be noted that when $E_2$ is greater than or equal to $E_1/2$, the transmitter performs bit reversal shortening on the to-be-retransmitted bit sequence, to shorten the to-be-retransmitted bit sequence to a length of $E_1$, and then performs puncturing in the natural order until the length of the final retransmission bit sequence is $E_2$; or when $E_2$ is less than Ei/2, first punctures all bits whose sequence numbers fall within [0, N/2-1], and then performs bit reversal shortening on the remaining N/2 bits until the length of the final retransmission bit sequence is $E_2$.

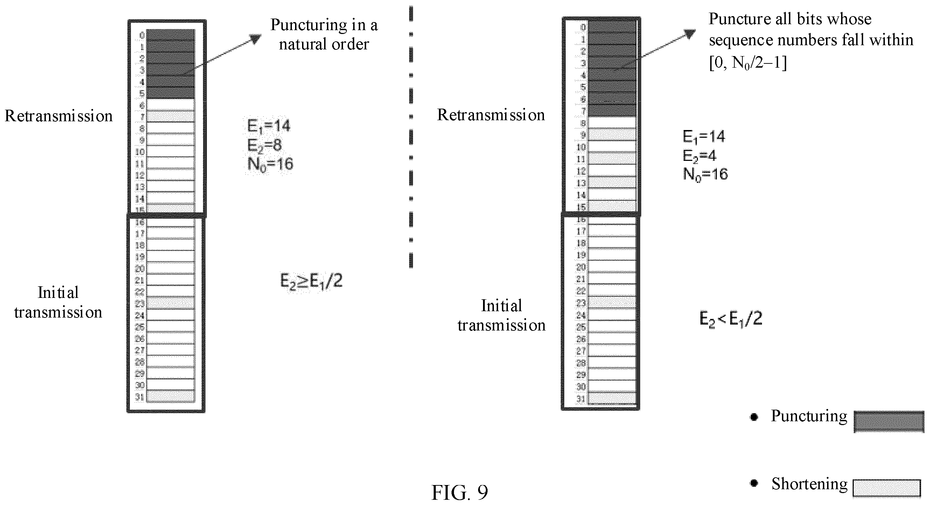

For ease of understanding, FIG. 9 is used as an example herein for further explanation. It is assumed that the length of the initial transmission bit sequence is 14 bits, and the corresponding mother code length is 16 bits. Therefore, two bit locations need to be shortened. Based on bit reversal shortening, a sequence number of each bit location is denoted as a sequence number that falls within [1, 15]. In this case, two bit locations with largest sequence numbers are respectively bit locations corresponding to sequence numbers 14 and 15, and corresponding binary representations of the bit locations are [14(1110), 15(1111)]. The 4-bit binary representations are reversed, and [7(0111), 15(1111)] may be obtained. That is, after a bit reversal operation is performed, locations that finally need to be shortened are bit locations corresponding to sequence numbers 7 and 15. In FIG. 8, the initial transmission bit sequence and the retransmission bit sequence are combined into a long code. Therefore, the mother code length N is added to all bit locations in the initial transmission bit sequence. In this case, shortened bit locations are changed to bit locations corresponding to sequence numbers 23 and 31.

After the initial transmission bit sequence is determined, rate matching is performed below for retransmission.

It is assumed that the length $E_2$ of the retransmission bit sequence is 8 bits. In this case, $f(E_1)=E_1/2=7$, and a condition that $E_2$ is greater than or equal to Ei/2 is met. Therefore, a rate matching method shown on a left side in FIG. 9 is used, that is, bit reversal shortening is performed. It may be learned from the foregoing method that bit locations that need to be shortened are consistent with those for initial transmission. That is, bit locations corresponding to sequence numbers 7 and 15 are first shortened, and then the retransmission part is shortened to the required length $E_2$ of the retransmission bit sequence according to a natural order puncturing method. In this case, if a shortened location is touched when puncturing is performed in the natural order, the shortened location is skipped. It is assumed that the length of the retransmission bit sequence is 4 bits. In this case, a condition that $E_2$ is less than Ei/2 is met. Therefore, a rate matching method shown on a right side in FIG. 9 is used. That is, bit locations whose sequence numbers fall within [0, 7] in the retransmission part are fixed punctured locations, and then the remaining N/2 bit locations, that is, bit locations whose sequence numbers fall within [8, 15], are shortened to 4 bits according to a bit reversal shortening method. It may be learned from the foregoing bit reversal shortening method that locations that are finally shortened are bit locations corresponding to sequence numbers 9, 11, 13, and 15.

A rate matching rule used when $f(E_1)$ is represented as $E_1/2$ and the length $E_2$ of the retransmission bit sequence is less than or equal to the length $E_1$ of the initial transmission bit sequence is provided above. In another possible implementation, when the length $E_2$ of the retransmission bit sequence is greater than the length $E_1$ of the initial transmission bit sequence, the retransmission part may be shortened to $E_2$ based on the length N of the initial transmission mother code. If $E_2$ is greater than N, rate matching is performed by using a repetition operation.

The foregoing describes the method in embodiments of this application. The following describes an apparatus in embodiments of this application. The method and the apparatus are based on a same technical concept. The method and the apparatus have similar principles for resolving problems. Therefore, for implementations of the apparatus and the method, mutual reference may be made. Repeated parts are not described.

In embodiments of this application, the apparatus may be divided into functional modules based on the foregoing method examples. For example, each functional module may be obtained through division based on each corresponding function, or two or more functions may be integrated into one module. These modules may be implemented in a form of hardware, or may be implemented in a form of a software functional module. It should be noted that in embodiments of this application, division into the modules is an example, and is merely logical function division. During specific implementation, another division manner may be used.

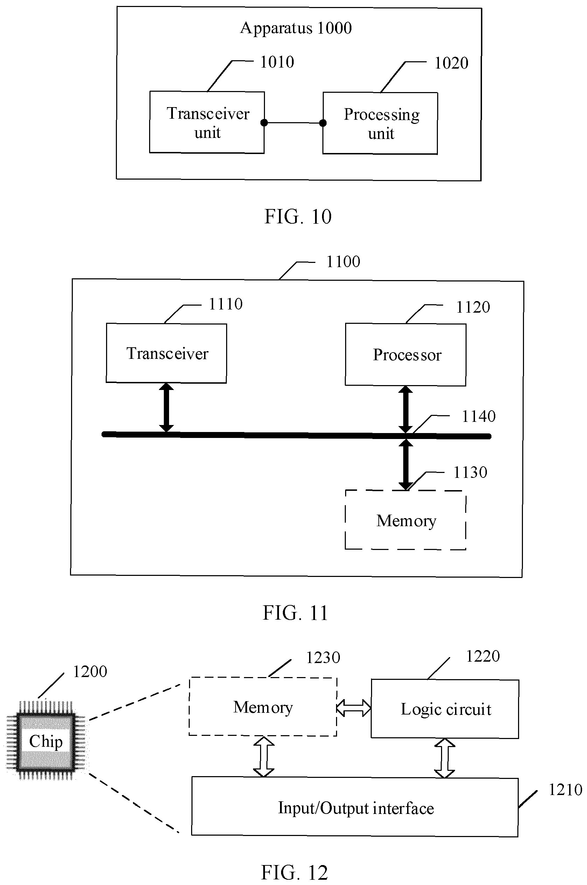

Based on a same technical concept as the foregoing method, FIG. 10 is a schematic diagram of a structure of a rate matching apparatus 1000. The apparatus 1000 may be a transmitter or a chip or a functional unit used for a transmitter; or may be a receiver or a chip or a functional unit used for a receiver.

When the apparatus 1000 is configured to perform an operation performed by the transmitter, the apparatus 1000 has any function of the transmitter in the foregoing method.

In a possible implementation, a transceiver unit 1010 and a processing unit 1020 may be further configured to perform the following steps in the foregoing method. An example is as follows:

The transceiver unit 1010 obtains a to-be-coded bit sequence;

the processing unit 1020 performs polar coding on the to-be-coded bit sequence, to obtain a first bit sequence, where a length of the first bit sequence is N;
the processing unit 1020 performs first rate matching on the first bit sequence, to obtain a second bit sequence, where a length of the second bit sequence is $E_1$; and the transceiver unit sends the second bit sequence;
the processing unit 1020 performs polar coding based on the to-be-coded bit sequence, to obtain a third bit sequence, where a length of the third bit sequence is 2*N;
the processing unit 1020 performs second rate matching on the third bit sequence, to obtain a fourth bit sequence, where a length of the fourth bit sequence is $E_2$, where
the second rate matching is determined based on a relationship between $f(E_1)$ and $E_2$, and a value of $f(E_1)$ is determined based on $E_1$; and
the transceiver unit 1010 sends the fourth bit sequence, where
N, $E_1$, and $E_2$ are positive integers.

In a possible implementation, $f(E_1)=a*E_1+b$, where a is a constant greater than 0 and less than or equal to 1, and b is a constant whose absolute value is less than $E_1$.

In a possible implementation, when $E_2$ is greater than or equal to $f(E_1)$, the second rate matching is performed based on a fifth bit sequence; or when $E_2$ is less than $f(E_1)$, the second rate matching includes: puncturing all bits whose sequence numbers fall within [0, N/2-1] in a fifth bit sequence, and performing third rate matching on all bits whose sequence numbers fall within [N/2, N-1] in the fifth bit sequence, where the fifth bit sequence consists of all bits whose sequence numbers fall within [0, N-1] in the third bit sequence.

In this implementation, the fifth bit sequence is a first half of the third bit sequence, that is, the fifth bit sequence consists of all the bits whose sequence numbers fall within [0, N-1] in the third bit sequence. When $E_2$ is greater than or equal to $f(E_1)$, the second rate matching is performed based on the mother code length N. When $E_2$ is less than $f(E_1)$, the second rate matching is performed based on a half of the mother code length, that is, N/2.

In a possible implementation, when $E_2$ is greater than or equal to $f(E_1)$:

when $E_2$ is less than N, the second rate matching is bit reversal shortening; or when $E_2$ is greater than N, the second rate matching is repetition; or
when $E_2$ is less than $f(E_1)$:

when $E_2$ is less than N/2, the third rate matching is bit reversal shortening; or when $E_2$ is greater than N/2, the third rate matching is repetition, where
$f(E_1)$ is $E_1$-N/16.

In a possible implementation, when $E_2$ is greater than or equal to $f(E_1)$,

the second rate matching includes: bit reversal shortening on the fifth bit sequence, and then puncturing in a natural order; or
when $E_2$ is less than $f(E_1)$,
the third rate matching is bit reversal shortening, where
$f(E_1)$ is $E_1$/2.

In a possible implementation, N is determined based on $E_1$. Specifically, $N=2^{\wedge}\lceil \log2(E_1) \rceil$.

In a possible implementation, the first rate matching is bit reversal shortening.

When the apparatus 1000 is configured to perform an operation performed by the receiver, the apparatus 1000 has any function of the receiver in the foregoing method.

In a possible implementation, a transceiver unit 1010 and a processing unit 1020 may be further configured to perform the following steps in the foregoing method. An example is as follows:

The transceiver unit 1010 obtains a first sequence, where a length of the first sequence is $E_1$, and a mother code length corresponding to the first sequence is N; and the processing unit rate de-matches the first sequence and then decodes the de-matched first sequence based on a manner of first rate matching;

the transceiver unit 1010 obtains a second sequence, where a length of the second sequence is $E_2$; and
the processing unit 1020 rate de-matches a third sequence and then decodes a rate de-matched third sequence based on the manner of first rate matching and a manner of second rate matching, where the third sequence consists of the first sequence and the second sequence, a mother code length corresponding to the third sequence is 2*N, the second rate matching is determined based on a relationship between $f(E_1)$ and $E_2$, and a value of $f(E_1)$ is determined based on $E_1$, where
N, $E_1$, and $E_2$ are positive integers.

In a possible implementation, $f(E_1)=a*E_1+b$, where a is a constant greater than 0 and less than or equal to 1, and b is a constant whose absolute value is less than $E_1$.

In a possible implementation, when $E_2$ is greater than or equal to $f(E_1)$, the second rate matching is performed based on a fifth bit sequence; or when $E_2$ is less than $f(E_1)$, the second rate matching includes: puncturing all bits whose sequence numbers fall within [0, N/2-1] in a fifth bit sequence, and performing third rate matching on all bits whose sequence numbers fall within [N/2, N-1] in the fifth bit sequence, where the fifth bit sequence consists of all bits whose sequence numbers fall within [0, N-1] in the third bit sequence.

In this implementation, the fifth bit sequence is a first half of the third bit sequence, that is, the fifth bit sequence consists of all the bits whose sequence numbers fall within [0, N-1] in the third bit sequence. When $E_2$ is greater than or equal to $f(E_1)$, the second rate matching is performed based on the mother code length N. When $E_2$ is less than $f(E_1)$, the second rate matching is performed based on a half of the mother code length, that is, N/2.

In a possible implementation, when $E_2$ is greater than or equal to $f(E_1)$:

when $E_2$ is less than N, the second rate matching is bit reversal shortening; or when $E_2$ is greater than N, the second rate matching is repetition; or
when $E_2$ is less than $f(E_1)$:

when $E_2$ is less than N/2, the third rate matching is bit reversal shortening; or when $E_2$ is greater than N/2, the third rate matching is repetition, where
$f(E_1)$ is $E_1$-N/16.

In a possible implementation, when $E_2$ is greater than or equal to $f(E_1)$,

the second rate matching includes: bit reversal shortening on the fifth bit sequence, and then puncturing in a natural order; or
when $E_2$ is less than $f(E_1)$,
the third rate matching is bit reversal shortening, where
$f(E_1)$ is $E_1/2$.

In a possible implementation, N is determined based on $E_1$. Specifically, $N=2^{\wedge \lceil \log 2(E_1) \rceil}$.

In a possible implementation, the first rate matching is bit reversal shortening.

As shown in FIG. 11, an embodiment of this application further provides an apparatus 1100. The apparatus 1100 is configured to implement a function of the transmitter or the receiver in the foregoing method. The apparatus may be a transmitter or a receiver, an apparatus in a transmitter or a receiver, or an apparatus that can be used in matching with a transmitter or a receiver. The apparatus 1100 may be a chip system. In embodiments of this application, the chip system may include a chip, or may include a chip and another discrete device. The apparatus 1100 includes at least one processor 1120, configured to implement a function of the transmitter or the receiver in the method provided in embodiments of this application. The apparatus 1100 may further include a transceiver 1110.

The apparatus 1100 may be specifically configured to perform a related method performed by the transmitter in the foregoing method embodiments. An example is as follows:

The transceiver 1110 obtains a to-be-coded bit sequence;

the processor 1120 performs polar coding on the to-be-coded bit sequence, to obtain a first bit sequence, where a length of the first bit sequence is N;
the processor 1120 performs first rate matching on the first bit sequence, to obtain a second bit sequence, where a length of the second bit sequence is $E_1$; and the transceiver unit sends the second bit sequence;
the processor 1120 performs polar coding based on the to-be-coded bit sequence, to obtain a third bit sequence, where a length of the third bit sequence is 2*N;
the processor 1120 performs second rate matching on the third bit sequence, to obtain a fourth bit sequence, where a length of the fourth bit sequence is $E_2$, where
the second rate matching is determined based on a relationship between $f(E_1)$ and $E_2$, and a value of $f(E_1)$ is determined based on $E_1$; and
the transceiver 1110 sends the fourth bit sequence, where
N, $E_1$, and $E_2$ are positive integers.

The apparatus 1100 may be specifically configured to perform a related method performed by the receiver in the foregoing method embodiments. An example is as follows:

The transceiver 1110 obtains a first sequence, where a length of the first sequence is $E_1$, and a mother code length corresponding to the first sequence is N; and the processing unit rate de-matches the first sequence and then decodes the rate de-matched first sequence based on a manner of first rate matching;

the transceiver 1110 obtains a second sequence, where a length of the second sequence is $E_2$; and
the processor 1120 rate de-matches a third sequence and then decodes a rate de-matched third sequence based on the manner of first rate matching and a manner of second rate matching, where the third sequence consists of the first sequence and the second sequence, a mother code length corresponding to the third sequence is 2*N, the second rate matching is determined based on a relationship between $f(E_1)$ and $E_2$, and a value of $f(E_1)$ is determined based on $E_1$, where
N, $E_1$, and $E_2$ are positive integers.

The apparatus 1100 may further include at least one memory 1130, configured to store program instructions and/or data. The memory 1130 is coupled to the processor 1120. In embodiments of this application, the coupling may be an indirect coupling or a communication connection between apparatuses, units, or modules, may be in an electronic form, a mechanical form, or another form, and is used for information exchange between the apparatuses, the units, or the modules. The processor 1120 may cooperate with the memory 1130. The processor 1120 may execute the program instructions stored in the memory 1130. In a possible implementation, at least one of the at least one memory may be integrated with the processor. In another possible implementation, the memory 1130 is located outside the apparatus 1100.

A specific connection medium between the transceiver 1110, the processor 1120, and the memory 1130 is not limited in embodiments of this application. In embodiments of this application, the memory 1130, the processor 1120, and the transceiver 1110 are connected through a bus 1140 in FIG. 11. The bus is represented by using a thick line in FIG. 11. A connection manner between other components is merely an example for description, and constitutes no limitation. The bus may be classified into an address bus, a data bus, a control bus, and the like. For ease of representation, only one thick line is used to represent the bus in FIG. 11, but this does not mean that there is only one bus or only one type of bus.

In embodiments of this application, the processor 1120 may be one or more central processing units (Central Processing Unit, CPU). When the processor 1120 is one CPU, the CPU may be a single-core CPU or a multi-core CPU. The processor 1120 may be a general-purpose processor, a digital signal processor, an application-specific integrated circuit, a field programmable gate array or another programmable logic device, a discrete gate or transistor logic device, or a discrete hardware component, and may implement or perform the methods, steps, and logical block diagrams disclosed in embodiments of this application. The general-purpose processor may be a microprocessor, any conventional processor, or the like. The steps of the methods disclosed with reference to embodiments of this application may be directly performed and completed by a hardware processor, or may be performed and completed by using a combination of hardware in a processor and a software module.

In embodiments of this application, the memory 1130 may include but is not limited to a nonvolatile memory such as a hard disk drive (hard disk drive, HDD) or a solid-state drive (solid-state drive, SSD), a random access memory (Random Access Memory, RAM), an erasable programmable read-only memory (Erasable Programmable ROM, EPROM), a read-only memory (Read-Only Memory, ROM), a portable read-only memory (Compact Disc Read-Only Memory, CD-ROM), or the like. The memory is any other medium that can be configured to carry or store expected program code in a form of an instruction structure or a data structure and that can be accessed by a computer. However, this is not limited thereto. In embodiments of this application, the memory may alternatively be a circuit or any other apparatus that can implement a storage function, and is configured to store program instructions and/or data. The memory 1130 is used for related instructions and data.

As shown in FIG. 12, an embodiment of this application further provides an apparatus 1200 that may be configured to implement a function of the transmitter in the foregoing method. The apparatus 1200 may be a communication apparatus or a chip in a communication apparatus. The apparatus includes:

an input/output interface 1210 that obtains a to-be-coded bit sequence; and
a logic circuit 1220 that performs polar coding on the to-be-coded bit sequence, to obtain a first bit sequence, where a length of the first bit sequence is N, where
the logic circuit 1220 performs first rate matching on the first bit sequence, to obtain a second bit sequence, where a length of the second bit sequence is $E_1$; and the transceiver unit sends the second bit sequence;
the logic circuit 1220 performs polar coding based on the to-be-coded bit sequence, to obtain a third bit sequence, where a length of the third bit sequence is 2*N;
the logic circuit 1220 performs second rate matching on the third bit sequence, to obtain a fourth bit sequence, where a length of the fourth bit sequence is $E_2$, where
the second rate matching is determined based on a relationship between $f(E_1)$ and $E_2$, and a value of $f(E_1)$ is determined based on $E_1$; and
the input/output interface 1210 sends the fourth bit sequence, where
N, $E_1$, and $E_2$ are positive integers.

An apparatus 1200 that may be configured to implement a function of the receiver in the foregoing method is provided. The apparatus 1200 may be a communication apparatus or a chip in a communication apparatus. The apparatus includes:

an input/output interface 1210 that obtains a first sequence, where a length of the first sequence is $E_1$, and a mother code length corresponding to the first sequence is N; and the processing unit that rate de-matches the first sequence and then decodes the rate de-matched first sequence based on a manner of first rate matching, where
the input/output interface 1210 obtains a second sequence, where a length of the second sequence is $E_2$; and
the logic circuit 1220 rate de-matches a third sequence and then decodes a rate de-matched third sequence based on the manner of first rate matching and a manner of second rate matching, where the third sequence consists of the first sequence and the second sequence, a mother code length corresponding to the third sequence is 2*N, the second rate matching is determined based on a relationship between $f(E_1)$ and $E_2$, and a value of $f(E_1)$ is determined based on $E_1$, where

N, $E_1$, and $E_2$ are positive integers.

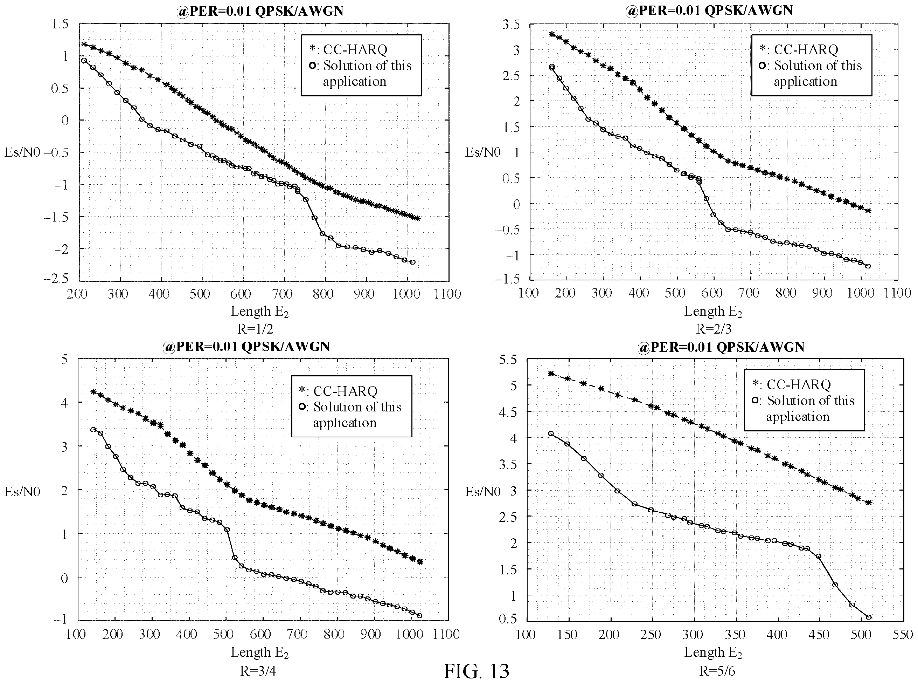

FIG. 13 is a performance simulation diagram of a solution of this application and a CC-HARQ when a quantity of to-be-coded bits is K=424. A horizontal coordinate is a length $E_2$ of a retransmission bit sequence, and a vertical coordinate is $E_s/N_0$, that is, a signal-to-noise ratio. For example, FIG. 13 separately provides performance simulation diagrams of the two solutions when a transmission code rate is R=1/2, R=2/3, R=3/4, and R=5/6. It may be clearly seen that at different transmission code rates, the solution of this application has better performance than the CC-HARQ. Specifically, when a bit error rate is 0.01, as the length $E_2$ of the retransmission bit sequence is continuously increased, signal-to-noise ratios required by the two solutions are continuously decreased, that is, an anti-interference capability is enhanced as the length of the retransmission bit sequence is increased. In addition, when there is a same length for the retransmission bit sequence, a signal-to-noise ratio required for the solution of this application to achieve the bit error rate of 0.01 is less than a signal-to-noise ratio required for the CC-HARQ. That is, the solution of this application may achieve a system indicator in a worse communication condition. In comparison, the solution of this application has better performance at various different transmission code rates.

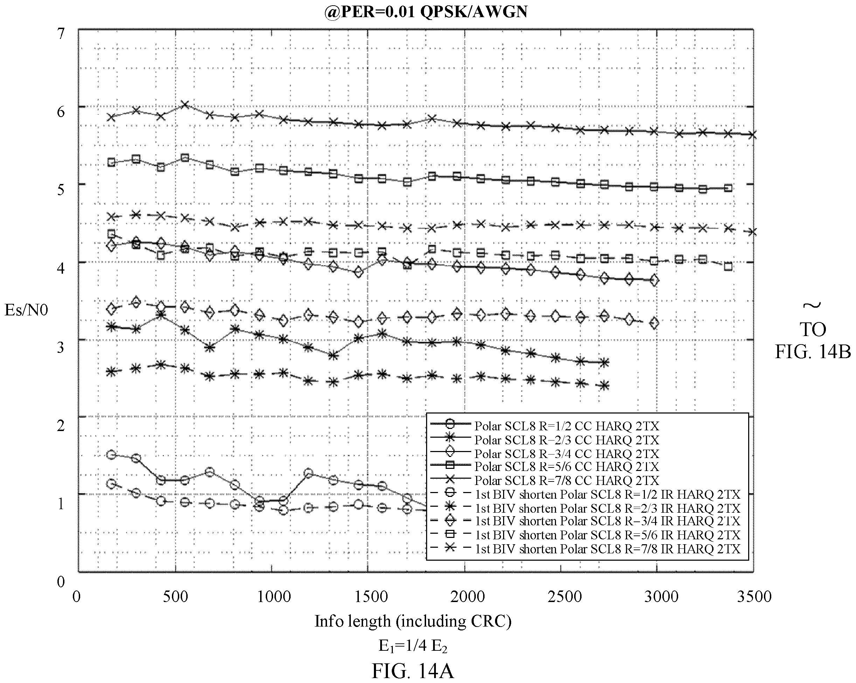

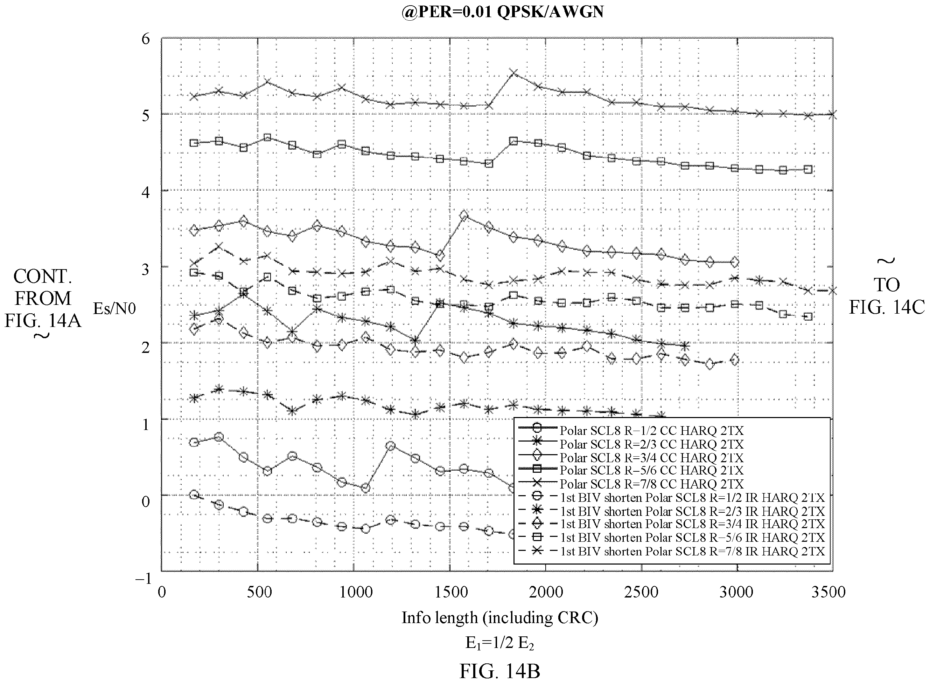

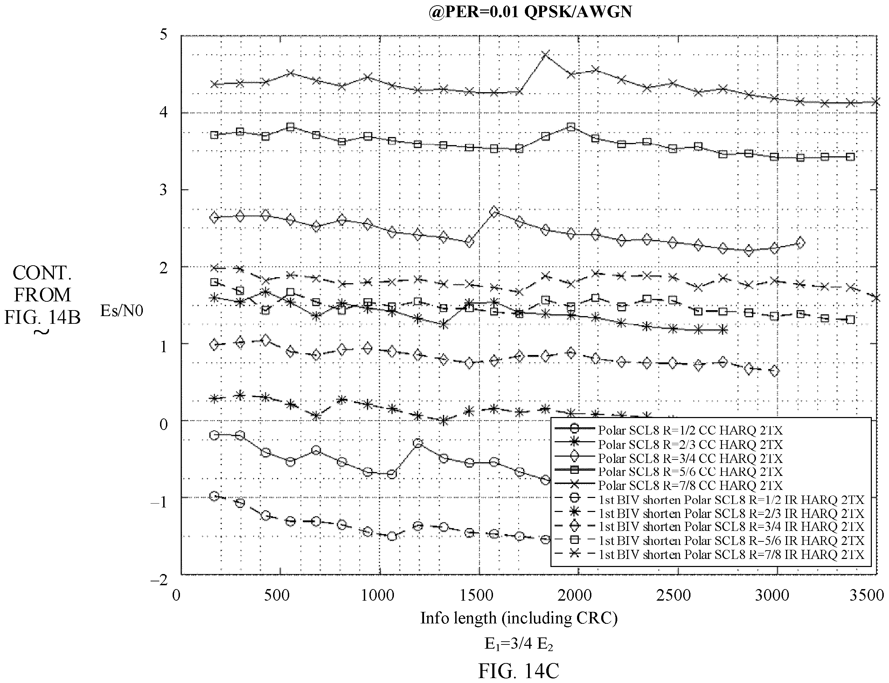

FIG. 14A, FIG. 14B, and FIG. 14C are another performance simulation diagram of a solution of this application and a CC-HARQ, and separately provides performance simulation diagrams of the two solutions in cases of different relationships between a length $E_1$ of an initial transmission bit sequence and a length $E_2$ of a retransmission bit sequence. For example, FIG. 14A, FIG. 14B, and FIG. 14C show performance simulation diagrams in cases of $E_1=1/4\ E_2$, $E_1=1/2\ E_2$, and $E_1=3/4\ E_2$. The case of $E_1=1/2\ E_2$ is used as an example for description. In the figure, a horizontal coordinate is a length of an information bit sequence, a vertical coordinate is a signal-to-noise ratio, a solid line is a performance simulation diagram of the CC-HARQ at different transmission code rates, and a dashed line is a performance simulation diagram of the solution of this application at different transmission code rates. Similarly, when a bit error rate is 0.01, at a same transmission code rate, a signal-to-noise ratio required for the solution of this application to achieve the bit error rate of 0.01 is less than a signal-to-noise ratio required for the CC-HARQ. That is, the solution of this application may achieve a system indicator in a worse communication condition. In comparison, the solution of this application has better performance at various different transmission code rates.

When the communication apparatus is a chip used in a terminal device, the chip in the terminal device implements a function of the terminal device in the foregoing method embodiments. The chip in the terminal device receives information from another module (for example, a radio frequency module or an antenna) in the terminal device, where the information is sent by a network device to the terminal device. Alternatively, the chip in the terminal device sends information to another module (for example, a radio frequency module or an antenna) in the terminal device, where the information is sent by the terminal device to a network device.

When the communication apparatus is a chip used in a network device, the chip in the network device implements a function of the network device in the foregoing method embodiments. The chip in the network device receives information from another module (for example, a radio frequency module or an antenna) in the network device, where the information is sent by a terminal device to the network device. Alternatively, the chip in the network device sends information to another module (for example, a radio frequency module or an antenna) in the network device, where the information is sent by the network device to a terminal device.

Based on a same concept as the foregoing method embodiments, an embodiment of this application further provides a computer-readable storage medium. The computer-readable storage medium stores a computer program, and the computer program is executed by hardware (for example, a processor) to implement some or all steps of any method performed by any apparatus in embodiments of this application.

Based on a same concept as the method embodiments, an embodiment of this application further provides a computer program product including instructions. When the computer program product is run on a computer, the computer is enabled to perform some or all steps of any method in the foregoing aspects.

Based on a same concept as the foregoing method embodiments, this application further provides a chip or a chip system. The chip may include a processor. The chip may further include a memory (or a storage module) and/or a transceiver (or a communication module), or the chip is coupled to a memory (or a storage module) and/or a transceiver (or a communication module). The transceiver (or the communication module) may be configured to support the chip in performing wired and/or wireless communication, and the memory (or the storage module) may be configured to store a program. The processor may invoke the program to implement an operation performed by the terminal or the network device in any one of the method embodiments or the possible implementations of the method embodiments. The chip system may include the foregoing chip, or may include the foregoing chip and another discrete device, for example, the memory (or the storage module) and/or the transceiver (or the communication module).

Based on a same concept as the foregoing method embodiments, this application further provides a communication system. The communication system may include the foregoing terminal and/or network device. The communication system may be configured to implement an operation performed by the terminal or the network device in any one of the method embodiments or the possible implementations of the method embodiments. For example, the communication system may have the structure shown in FIG. 1.

All or some of the foregoing embodiments may be implemented by using software, hardware, firmware, or any combination thereof. When software is used for implementation, all or some of the foregoing embodiments may be implemented in a form of a computer program product. The computer program product includes one or more computer instructions. When the computer program instructions are loaded and executed on a computer, all or some of the procedures or functions according to embodiments of this application are generated. The computer may be a general-purpose computer, a dedicated computer, a computer network, or another programmable apparatus. The computer instructions may be stored in a computer-readable storage medium, or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line) or wireless (for example, infrared, radio, or microwave) manner. The computer-readable storage medium may be any usable medium accessible by the computer, or a data storage device, for example, a server or a data center, into which one or more usable media are integrated. The usable medium may be a magnetic medium (for example, a floppy disk, a hard disk, or a magnetic tape), an optical medium (for example, an optical disc), a semiconductor medium (for example, a solid-state drive), or the like. In the foregoing embodiments, descriptions of embodiments have respective focuses. For a part that is not described in detail in an embodiment, refer to related descriptions in another embodiment.

In the foregoing embodiments, descriptions of embodiments have respective focuses. For a part that is not described in detail in an embodiment, refer to related descriptions in another embodiment.

In the several embodiments provided in this application, it should be understood that the disclosed apparatus may be implemented in other manners. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual indirect couplings or direct couplings or communication connections may be implemented by using some interfaces. The indirect couplings or communication connections between the apparatuses or units may be implemented in electronic or other forms.

The units described as separate parts may or may not be physically separate, and parts displayed as units may or may not be physical units, may be located at one location, or may be distributed on a plurality of network units. Some or all of the units may be selected based on actual requirements to achieve the objectives of the solutions in embodiments.

When the integrated unit is implemented in the form of a software functional unit and sold or used as an independent product, the integrated unit may be stored in a computer-readable storage medium. Based on such an understanding, the technical solutions of this application essentially, or the part contributing to the conventional technology, or all or some of the technical solutions may be implemented in a form of a software product. The computer software product is stored in a storage medium and includes several instructions for instructing a computer device (which may be a personal computer, a server, a network device, or the like) to perform all or some of the steps of the method in embodiments of this application.

The foregoing descriptions are merely some specific implementations of this application, but are not intended to limit the protection scope of this application. Any person skilled in the art may make other changes and modifications to these embodiments within the technical scope disclosed in this application. Therefore, the appended claims are intended to be construed as including the foregoing embodiments and the changes and modifications that fall within the scope of this application. Therefore, the protection scope of this application shall be subject to the protection scope of the claims.

**Claims**

1. A rate matching method, wherein the method comprises:

obtaining, by a transmitter, a to-be-coded bit sequence;
performing, by the transmitter, polar coding on the to-be-coded bit sequence, to obtain a first bit sequence, wherein a length of the first bit sequence is N;
performing, by the transmitter, first rate matching on the first bit sequence, to obtain a second bit sequence, wherein a length of the second bit sequence is $E_1$;
sending, by the transmitter, the second bit sequence;
performing, by the transmitter, polar coding based on the to-be-coded bit sequence, to obtain a third bit sequence, wherein a length of the third bit sequence is 2*N;
performing, by the transmitter, second rate matching on the third bit sequence, to obtain a fourth bit sequence, wherein a length of the fourth bit sequence is $E_2$, the second rate matching is determined based on a relationship between $f(E_1)$ and $E_2$, and a value of $f(E_1)$ is determined based on $E_1$; and

sending, by the transmitter, the fourth bit sequence, wherein

$N$, $E_1$, and $E_2$ are positive integers.

**2.** The method according to claim 1, wherein

$$f(E_1)=a*E_1+b,$$

wherein a is a constant greater than 0 and less than or equal to 1, and b is a constant whose absolute value is less than or equal to $E_1$.

**3.** The method according to claim 1 or 2, wherein

when $E_2$ is greater than or equal to $f(E_1)$, the second rate matching is performed based on a fifth bit sequence; or when $E_2$ is less than $f(E_1)$, the second rate matching comprises: puncturing all bits whose sequence numbers fall within [0, N/2-1] in the fifth bit sequence, and performing third rate matching on all bits whose sequence number fall within [N/2, N-1] in the fifth bit sequence, wherein

the fifth bit sequence consists of all bits whose sequence number fall within [0, N-1] in the third bit sequence.

**4.** The method according to any one of claims 1 to 3, wherein

when $E_2$ is greater than or equal to $f(E_1)$:

when $E_2$ is less than N, the second rate matching is bit reversal shortening; or when $E_2$ is greater than or equal to N, the second rate matching is repetition; or

when $E_2$ is less than $f(E_1)$:

when $E_2$ is less than N/2, the third rate matching is bit reversal shortening; or when $E_2$ is greater than or equal to N/2, the third rate matching is repetition, wherein $f(E_1)$ is $E_1$-N/16.

**5.** The method according to any one of claims 1 to 3, wherein

when $E_2$ is greater than or equal to $f(E_1)$,
the second rate matching comprises: bit reversal shortening on the fifth bit sequence, and then puncturing in a natural order; or
when $E_2$ is less than $f(E_1)$,
the third rate matching is bit reversal shortening, wherein
$f(E_1)$ is $E_1$/2.

**6.** The method according to any one of claims 1 to 5, wherein
N is determined based on $E_1$.

**7.** The method according to claim 1, wherein
the first rate matching is bit reversal shortening.

**8.** A rate matching method, wherein the method comprises:

obtaining, by a receiver, a first sequence, wherein a length of the first sequence is $E_1$, and a mother code length corresponding to the first sequence is N;
by the receiver, based on a manner of first rate matching, rate de-matching the first sequence and then decoding the rate de-matched first sequence;
obtaining, by the receiver, a second sequence, wherein a length of the second sequence is $E_2$; and
by the receiver, based on the manner of first rate matching and a manner of second rate matching, rate de-matching a third sequence and then decoding a rate de-matched third sequence, wherein the third sequence consists of the first sequence and the second sequence, and a mother code length corresponding to the third sequence is 2*N, wherein
the second rate matching is determined based on a relationship between $f(E_1)$ and $E_2$, and a value of $f(E_1)$ is determined based on $E_1$; and
N, $E_1$, and $E_2$ are positive integers.

**9.** The method according to claim 8, wherein

$$f(E_1)=a*E_1+b,$$

wherein a is a constant greater than 0 and less than or equal to 1, and b is a constant whose absolute value is less than or equal to $E_1$.

**10.** The method according to claim 8 or 9, wherein

when $E_2$ is greater than or equal to $f(E_1)$, the second rate matching is performed based on a fifth bit sequence; or
when $E_2$ is less than $f(E_1)$, the second rate matching comprises: puncturing all bits whose sequence numbers fall within [0, N/2-1] in the fifth bit sequence, and performing third rate matching on all bits whose sequence numbers fall within [N/2, N-1] in the fifth bit sequence, wherein
the fifth bit sequence consists of all bits whose sequence numbers fall within [0, N-1] in the third bit sequence.

**11.** The method according to any one of claims 8 to 10, wherein

when $E_2$ is greater than or equal to $f(E_1)$:

when $E_2$ is less than N, the second rate matching is bit reversal shortening; or
when $E_2$ is greater than or equal to N, the second rate matching is repetition; or

when $E_2$ is less than $f(E_1)$:

when $E_2$ is less than N/2, the third rate matching is bit reversal shortening; or
when $E_2$ is greater than or equal to N/2, the third rate matching is repetition, wherein $f(E_1)$ is $E_1$-N/16.

**12.** The method according to any one of claims 8 to 10, wherein

when $E_2$ is greater than or equal to $f(E_1)$,
the second rate matching comprises: bit reversal shortening on the fifth bit sequence, and then puncturing in a natural order; or
when $E_2$ is less than $f(E_1)$,
the third rate matching is bit reversal shortening, wherein
$f(E_1)$ is $E_1$/2.

**13.** The method according to any one of claims 8 to 12, wherein
N is determined based on $E_1$.

**14.** The method according to claim 1,
the first rate matching is bit reversal shortening.

**15.** A rate matching apparatus, used for a transmitter, wherein the apparatus comprises a transceiver unit and a processing unit;

the transceiver unit obtains a to-be-coded bit sequence;
the processing unit performs polar coding on the to-be-coded bit sequence, to obtain a first bit sequence, wherein a length of the first bit sequence is N;
the processing unit performs first rate matching on the first bit sequence, to obtain a second bit sequence, wherein a length of the second bit sequence is $E_1$;
the transceiver unit sends the second bit sequence;
the processing unit performs polar coding based on the to-be-coded bit sequence, to obtain a third bit sequence, wherein a length of the third bit sequence is 2*N;

the processing unit performs second rate matching on the third bit sequence, to obtain a fourth bit sequence, wherein a length of the fourth bit sequence is $E_2$, the second rate matching is determined based on a relationship between $f(E_1)$ and $E_2$, and a value of $f(E_1)$ is determined based on $E_1$; and

the transceiver unit sends the fourth bit sequence, wherein

N, $E_1$, and $E_2$ are positive integers.

**16.** The apparatus according to claim 15, wherein

$$f(E_1)=a*E_1+b,$$

wherein a is a constant greater than 0 and less than or equal to 1, and b is a constant whose absolute value is less than or equal to $E_1$.

**17.** The apparatus according to claim 15 or 16, wherein

when $E_2$ is greater than or equal to $f(E_1)$, the second rate matching is performed based on a fifth bit sequence; or

when $E_2$ is less than $f(E_1)$, the second rate matching comprises: puncturing all bits whose sequence numbers fall within [0, N/2-1] in the fifth bit sequence, and performing third rate matching on all bits whose sequence numbers fall within [N/2, N-1] in the fifth bit sequence, wherein

the fifth bit sequence consists of all bits whose sequence numbers fall within [0, N-1] in the third bit sequence.

**18.** The apparatus according to any one of claims 15 to 17, wherein

when $E_2$ is greater than or equal to $f(E_1)$:

when $E_2$ is less than N, the second rate matching is bit reversal shortening; or

when $E_2$ is greater than or equal to N, the second rate matching is repetition; or

when $E_2$ is less than $f(E_1)$:

when $E_2$ is less than N/2, the third rate matching is bit reversal shortening; or

when $E_2$ is greater than or equal to N/2, the third rate matching is repetition, wherein $f(E_1)$ is represented as $E_1$-N/16.

**19.** The apparatus according to any one of claims 15 to 17, wherein

when $E_2$ is greater than or equal to $f(E_1)$,

the second rate matching comprises: bit reversal shortening on the fifth bit sequence, and then puncturing in a natural order; or

when $E_2$ is less than $f(E_1)$,

the third rate matching is bit reversal shortening, wherein

$f(E_1)$ is represented as $E_1$/2.

**20.** The apparatus according to any one of claims 15 to 19, wherein

N is determined based on $E_1$.

**21.** The apparatus according to claim 15, wherein

the first rate matching is bit reversal shortening.

**22.** A rate matching apparatus, used for a receiver, wherein the apparatus comprises a transceiver unit and a processing unit;

the transceiver unit obtains a first sequence, wherein a length of the first sequence is $E_1$, and a mother code length corresponding to the first sequence is N;

the processing unit rate de-matches the first sequence and then decodes the rate de-matched first sequence based on a manner of first rate matching;

the transceiver unit obtains a second sequence, wherein a length of the second sequence is $E_2$; and
the processing unit rate de-matches the third sequence and then decodes the rate de-matched third sequence based on the manner of first rate matching and a manner of second rate matching, wherein the third sequence consists of the first sequence and the second sequence, and a mother code length corresponding to the third sequence is 2*N, wherein
the second rate matching is determined based on a relationship between $f(E_1)$ and $E_2$, and a value of $f(E_1)$ is determined based on $E_1$; and
N, $E_1$, and $E_2$ are positive integers.

**23.** The apparatus according to claim 22, wherein

$$f(E_1)=a*E_1+b,$$

wherein a is a constant greater than 0 and less than or equal to 1, and b is a constant whose absolute value is less than or equal to $E_1$.

**24.** The apparatus according to claim 22 or 23, wherein

when $E_2$ is greater than or equal to $f(E_1)$, the second rate matching is performed based on a fifth bit sequence; or
when $E_2$ is less than $f(E_1)$, the second rate matching comprises: puncturing all bits whose sequence numbers fall within [0, N/2-1] in the fifth bit sequence, and performing third rate matching on all bits whose sequence numbers fall within [N/2, N-1] in the fifth bit sequence.

**25.** The apparatus according to any one of claims 22 to 24, wherein

when $E_2$ is greater than or equal to $f(E_1)$:

when $E_2$ is less than N, the second rate matching is bit reversal shortening; or
when $E_2$ is greater than or equal to N, the second rate matching is repetition; or

when $E_2$ is less than $f(E_1)$:

when $E_2$ is less than N/2, the third rate matching is bit reversal shortening; or
when $E_2$ is greater than or equal to N/2, the third rate matching is repetition, wherein $f(E_1)$ is $E_1$-N/16.

**26.** The apparatus according to any one of claims 22 to 24, wherein

when $E_2$ is greater than or equal to $f(E_1)$,
the second rate matching comprises: bit reversal shortening on the fifth bit sequence, and then puncturing in a natural order; or
when $E_2$ is less than $f(E_1)$,
the third rate matching is bit reversal shortening, wherein
$f(E_1)$ is represented as $E_1/2$.

**27.** The apparatus according to any one of claims 22 to 26, wherein
N is determined based on $E_1$.

**28.** The apparatus according to claim 22, wherein
the first rate matching is bit reversal shortening.

**29.** A communication apparatus, comprising:
a processor, wherein the processor is coupled to a memory, the memory is configured to store a computer program or instructions, and the processor is configured to execute the computer program or the instructions, to implement the method according to any one of claims 1 to 7 or the method according to any one of claims 8 to 14.

**30.** A communication apparatus, comprising a logic circuit and an input/output interface, wherein

the input/output interface is configured to input a to-be-coded bit sequence;
the input/output interface is further configured to output a second bit sequence and a fourth bit sequence; and
the logic circuit is configured to implement the method according to any one of claims 1 to 7.

31. A communication apparatus, comprising a logic circuit and an input/output interface, wherein

the input/output interface is configured to input a first sequence and a second sequence; and
the logic circuit is configured to implement the method according to any one of claims 8 to 14.

32. A computer-readable storage medium, wherein the computer-readable storage medium stores a computer program or instructions, and when the instructions are run on a computer, the method according to any one of claims 1 to 7 or the method according to any one of claims 8 to 14 is performed.

33. A computer program product, comprising computer-executable instructions, wherein when the computer-executable instructions are run on a computer, the method according to any one of claims 1 to 7 or the method according to any one of claims 8 to 14 is performed.

33. A communication apparatus, configured to perform the method according to any one of claims 1 to 7.

34. A communication apparatus, configured to perform the method according to any one of claims 8 to 14.

35. A computer program, wherein when the computer program is run on a computer, the method according to any one of claims 1 to 7 or the method according to any one of claims 8 to 14 is performed.

36. A communication system, comprising the apparatus according to any one of claims 15 to 21 and the apparatus according to any one of claims 22 to 28.

FIG. 1

FIG. 2

High
reliability

Mapping to a
polar sub-channel

Low
reliability

FIG. 3

Coder (one retransmission and two transmissions in total)

```
┌─────┐     ┌────────┐     ┌─────┐                    ┌─────┐
│  N  │────▶│ Polar  │────▶│  C  │─────────────▶ ⊕ ──▶│  C  │
│  2  │     │ coder  │     │  2' │                    │  2  │
└─────┘     └────────┘     └─────┘                    └─────┘
                                                         Transmitted
┌─────┐     ┌────────┐     ┌─────┐     ┌─────┐            codeword
│  N  │────▶│ Polar  │────▶│  C  │────▶│  C  │
│  1  │     │ coder  │     │  1' │     │  1  │
└─────┘     └────────┘     └─────┘     └─────┘
```

$N_2$                                    $N_1$

Extended part
(second transmission)

Original part
(first transmission)

Frozen bit        Checked bit        Information
bit

Check bit
"One-to-one"

FIG. 4

Transmitter

Receiver

S501: Obtain a to-be-coded bit sequence

S502: Perform polar coding on the to-be-coded bit sequence, to obtain a first bit sequence

S503: Perform first rate matching on the first bit sequence, to obtain a second bit sequence

S504: Second bit sequence

S505: Perform polar coding on the to-be-coded bit sequence, to obtain a third bit sequence

S504a: Obtain a first sequence

S504b: Rate de-match the first sequence and then decode the rate de-matched first sequence based on a manner of first rate matching,

S506: Perform second rate matching on the third bit sequence, to obtain a fourth bit sequence

S507: Fourth bit sequence

S507a: Obtain a second sequence

S507b: Rate de-match a third sequence and then decode a rate de-matched third sequence based on the manner of first rate matching and a manner of second rate matching, where the third sequence includes the first sequence and the second sequence

FIG. 5

FIG. 6

FIG. 7

Retransmission

Initial transmission

(a)

Fixed location for puncturing

Retransmission

Initial transmission

(b)

● Puncturing

● Shortening

FIG. 8

FIG. 9

FIG. 10

FIG. 11

FIG. 12

FIG. 13

EP 4 436 076 A1

**@PER=0.01 QPSK/AWGN**

Es/N0

Info length (including CRC)

$E_1=1/4\ E_2$

Legend:
- ⊖ Polar SCL8 R=1/2 CC HARQ 2TX
- ✳ Polar SCL8 R=2/3 CC HARQ 2TX
- ◇ Polar SCL8 R=3/4 CC HARQ 2TX
- ☐ Polar SCL8 R=5/6 CC HARQ 2TX
- ✕ Polar SCL8 R=7/8 CC HARQ 2TX
- – ⊖ – 1st BIV shorten Polar SCL8 R=1/2 IR HARQ 2TX
- – ✳ – 1st BIV shorten Polar SCL8 R=2/3 IR HARQ 2TX
- – ◇ – 1st BIV shorten Polar SCL8 R=3/4 IR HARQ 2TX
- – ☐ – 1st BIV shorten Polar SCL8 R=5/6 IR HARQ 2TX
- – ✕ – 1st BIV shorten Polar SCL8 R=7/8 IR HARQ 2TX

TO
FIG. 14B

FIG. 14A

@PER=0.01 QPSK/AWGN

$E_1 = 1/2\ E_2$

FIG. 14B

CONT. FROM FIG. 14A

TO FIG. 14C

@PER=0.01 QPSK/AWGN

CONT. FROM FIG. 14B

Es/N0

Polar SCL8 R=1/2 CC HARQ 2TX
Polar SCL8 R=2/3 CC HARQ 2TX
Polar SCL8 R=3/4 CC HARQ 2TX
Polar SCL8 R=5/6 CC HARQ 2TX
Polar SCL8 R=7/8 CC HARQ 2TX
1st BIV shorten Polar SCL8 R=1/2 IR HARQ 2TX
1st BIV shorten Polar SCL8 R=2/3 IR HARQ 2TX
1st BIV shorten Polar SCL8 R=3/4 IR HARQ 2TX
1st BIV shorten Polar SCL8 R=5/6 IR HARQ 2TX
1st BIV shorten Polar SCL8 R=7/8 IR HARQ 2TX

Info length (including CRC)

$E_1=3/4\ E_2$

FIG. 14C

## INTERNATIONAL SEARCH REPORT

| International application No. |
|---|
| **PCT/CN2022/138313** |

| A. | CLASSIFICATION OF SUBJECT MATTER |
|---|---|
| | H04L1/00(2006.01)i;H04L1/18(2023.01)i |

According to International Patent Classification (IPC) or to both national classification and IPC

| B. | FIELDS SEARCHED |
|---|---|

Minimum documentation searched (classification system followed by classification symbols)

IPC:H04L,H04W

Documentation searched other than minimum documentation to the extent that such documents are included in the fields searched

Electronic data base consulted during the international search (name of data base and, where practicable, search terms used)

3GPP, CNABS, CNTXT, ENTXT, ETSI: 比特序列, 序列, 编码, 极化编码, 长度, 速率匹配, 速率适配初传, 初始, 开始, 逆序, 缩短, 打孔, 增量冗余混合自动重传, 重传, HARQ, IR, polar, encod+, rate, match+ bite?, sequence, short+, retransmi+, length

| C. | DOCUMENTS CONSIDERED TO BE RELEVANT |
|---|---|

| Category* | Citation of document, with indication, where appropriate, of the relevant passages | Relevant to claim No. |
|---|---|---|
| A | CN 106817195 A (HUAWEI TECHNOLOGIES CO., LTD.) 09 June 2017 (2017-06-09) description, paragraphs 88-177 | 1-36 |
| A | CN 110048802 A (HUAWEI TECHNOLOGIES CO., LTD.) 23 July 2019 (2019-07-23) entire document | 1-36 |
| A | CN 110572245 A (HUAWEI TECHNOLOGIES CO., LTD.) 13 December 2019 (2019-12-13) entire document | 1-36 |
| A | WO 2020042161 A1 (NOKIA SHANGHAI BELL CO., LTD.; NOKIA SOLUTIONS & NETWORKS OY; NOKIA TECHNOLOGIES OY) 05 March 2020 (2020-03-05) entire document | 1-36 |
| A | INTEL CORPORATION. "R1-1612585 "Discussion on EMBB data channel coding for block lengths less than X"" *3GPP tsg_ran\WG1_RL1*, No. TSGR1_87, 06 November 2016 (2016-11-06), entire document | 1-36 |

☐ Further documents are listed in the continuation of Box C.  ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **10 March 2023** | **11 March 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

<div align="center">

**INTERNATIONAL SEARCH REPORT**
**Information on patent family members**

</div>

| International application No. |
| --- |
| **PCT/CN2022/138313** |

| Patent document cited in search report | | | Publication date (day/month/year) | Patent family member(s) | | | Publication date (day/month/year) |
| --- | --- | --- | --- | --- | --- | --- | --- |
| CN | 106817195 | A | 09 June 2017 | WO | 2017092543 | A1 | 08 June 2017 |
| CN | 110048802 | A | 23 July 2019 | WO | 2019141165 | A1 | 25 July 2019 |
| | | | | US | 2020350932 | A1 | 05 November 2020 |
| | | | | EP | 3731443 | A1 | 28 October 2020 |
| | | | | EP | 3731443 | A4 | 17 February 2021 |
| | | | | EP | 3731443 | B1 | 21 September 2022 |
| CN | 110572245 | A | 13 December 2019 | WO | 2018201831 | A1 | 08 November 2018 |
| | | | | EP | 3570476 | A1 | 20 November 2019 |
| | | | | EP | 3570476 | A4 | 29 January 2020 |
| | | | | BR | 112019022803 | A2 | 26 May 2020 |
| | | | | US | 2019393978 | A1 | 26 December 2019 |
| | | | | US | 10985868 | B2 | 20 April 2021 |
| | | | | JP | 2020519174 | A | 25 June 2020 |
| | | | | US | 2019089484 | A1 | 21 March 2019 |
| | | | | US | 10419158 | B2 | 17 September 2019 |
| WO | 2020042161 | A1 | 05 March 2020 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202111522959